(19) Europäisches Patentamt
European Patent Office
Office européen des brevets

(11) **EP 4 176 468 B1**

(12) **FASCICULE DE BREVET EUROPEEN**

(45) Date de publication et mention de la délivrance du brevet:
**27.11.2024 Bulletin 2024/48**

(21) Numéro de dépôt: **21736747.3**

(22) Date de dépôt: **02.07.2021**

(51) Classification Internationale des Brevets (IPC):
*H10K 39/30* (2023.01)   *H10K 50/852* (2023.01)
*H10K 59/35* (2023.01)   *H10K 71/00* (2023.01)
*H10K 102/10* (2023.01)

(52) Classification Coopérative des Brevets (CPC):
**H10K 50/852; H10K 39/30; H10K 59/35;**
**H10K 71/621;** H10K 50/816; H10K 50/818;
H10K 2102/101

(86) Numéro de dépôt international:
**PCT/IB2021/055950**

(87) Numéro de publication internationale:
**WO 2022/003640 (06.01.2022 Gazette 2022/01)**

(54) **DISPOSITIF OPTOELECTRONIQUE ET PROCÉDÉ DE FABRICATION POUR UN DISPOSITIF OPTOELECTRONIQUE**

OPTOELEKTRONISCHE VORRICHTUNG UND VERFAHREN ZUR HERSTELLUNG EINER OPTOELEKTRONISCHEN VORRICHTUNG

OPTOELECTRONIC DEVICE AND METHOD FOR MANUFACTURING AN OPTOELECTRONIC DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.07.2020 FR 2006988**

(43) Date de publication de la demande:
**10.05.2023 Bulletin 2023/19**

(73) Titulaires:
• **Microoled**
**38000 Grenoble Cedex 9 (FR)**
• **Commissariat à l'Energie Atomique et aux Energies Alternatives**
**75015 Paris (FR)**

(72) Inventeurs:
• **HAAS, Gunther**
**38120 Saint Egrève (FR)**
• **DUGRENIL, Benoit**
**38000 Grenoble (FR)**
• **GUILLAMET, Sébastien**
**69003 Lyon (FR)**
• **TOURNAIRE, Myriam**
**38054 Grenoble Cedex 9 (FR)**
• **MAINDRON, Tony**
**38054 Grenoble Cedex 9 (FR)**

(74) Mandataire: **IXAS Conseil**
**22, avenue René Cassin**
**69009 Lyon (FR)**

(56) Documents cités:
**EP-A1- 3 671 849       US-A1- 2011 229 994**
**US-A1- 2017 187 001**

**Description**

**Domaine technique de l'invention**

L'invention relève du domaine de la microélectronique et plus précisément du domaine des dispositifs optoélectroniques en couches minces. Plus précisément, elle concerne un dispositif optoélectronique matriciel en couche minces présentant des couches actives qui sont des couches organiques, au sens chimique du terme. Ces dispositifs optoélectroniques peuvent être des écrans d'affichage de type OLED (Organic Light Emitting Device) ou des capteurs optiques dont les couches actives sont des couches organiques. Ils présentent une structure nouvelle avec une cavité optique de longueur optique différente pour chaque groupe de pixels de couleur différente.

L'invention concerne également un procédé nouveau pour fabriquer ces produits nouveaux.

**Etat de la technique**

On connaît des micro-afficheurs matriciels de type OLED qui présentent une taille de pixel inférieure à environ 20 μm, typiquement entre 6 μm et 12 μm. Dans un micro-afficheur couleur, chaque pixel est composé de plusieurs groupe de pixels dont la taille est inférieure à environ 10 μm, et qui est actuellement typiquement de l'ordre de 3 μm à 6 μm. Dans ces micro-afficheurs, la couleur des groupes de pixels rouge (abrégé R), vert (abrégé G (« green »)) et bleu (abrégé B) est générée par un empilement OLED à émission blanche commun à la matrice entière, chaque pixel étant doté de son filtre couleur spécifique. Certes, on connaît des empilements OLED conçus pour générer directement de la lumière rouge, verte ou bleue. Cependant, on ne peut pas les utiliser pour la fabrication de micro-afficheurs OLED, pour plusieurs raisons.

Tout d'abord, dans les micro-afficheurs OLED, la taille des pixels RGB est si petite qu'il n'est actuellement pas possible, avec une fiabilité industrielle suffisante, de structurer les empilements OLED au niveau des pixels R, G et B, de manière à obtenir des pixels qui émettent directement de la lumière de couleur voulue. En effet, la structuration des dépôts de couches OLED peut se faire par évaporation sous vide à travers un masque, mais avec une taille supérieure à environ 20 μm seulement.

Par ailleurs, le fait de déposer un empilement OLED commun à la matrice entière (i.e. sur une tranche de silicium comportant plusieurs dispositifs micro-afficheurs avec une résolution de la dimension du dispositif qui est de quelques millimètres) permet d'utiliser un procédé de dépôt simple et facile à contrôler, avec un bon rendement industriel.

Et enfin, les matériaux et procédés pour réaliser les filtres colorés sont disponibles, bien connus et éprouvés industriellement, dans la mesure où ils sont déjà utilisés pour les imageurs de type CMOS (Complementary Metal-Oxide-Semiconductor).

L'utilisation d'un empilement OLED commun, si elle est actuellement inévitable pour les micro-afficheurs OLED, présente cependant l'inconvénient d'une faible efficacité optique. En effet, la transmission optique des filtres dans la bande passante est entre 50% et 70% seulement. Par ailleurs, pour un émetteur blanc, on ne peut pas bénéficier d'un gain dans la direction normale par l'effet de cavité, contrairement à ce qui se fait pour des émetteurs RGB séparés. Au contraire, on se trouve typiquement dans une configuration dite à émission par le haut (en anglais « top émission »), i.e. avec une émission dans la direction opposée au substrat. Dans ce cas le dispositif OLED consiste essentiellement en une électrode réfléchissante en bas, l'empilement des couches organiques (OLED), et une électrode semi-transparente en haut. Cet ensemble forme une cavité optique, qui malheureusement va absorber une partie du spectre blanc émis par l'empilement OLED.

Il existe de nombreux documents brevet qui témoignent de l'importance et de la difficulté de ce problème connu depuis le début des années 90. Beaucoup d'inventeurs ont utilisé le principe d'incorporer des cavités optiques dans une structure OLED blanche ou d'une couleur donnée, pour en extraire des bandes spectrales par interférence, et pour ainsi, soit générer des primaires RGB par interférence, soit d'améliorer l'efficacité des systèmes à filtre coloré ou des systèmes avec des OLED RGB structurés au niveau du pixel.

A titre d'exemple, EP 0 616 488 A (Hitachi) de 1993 décrit, pour une configuration d'émission par le bas, i.e. à travers le substrat (en anglais « bottom émission »), un dispositif OLED avec au moins deux cavités optiques qui définissent les longueurs d'onde respectives d'émission. L'émetteur OLED met en œuvre un seul empilement qui génère un spectre suffisamment large pour couvrir toutes les différentes cavités optiques. La cavité optique comprend un miroir semi-transparent formé par un système multicouches diélectrique et une électrode réfléchissante sur la partie opposé au substrat, la cathode étant en oxyde transparent conducteur (abrégé TCO, en anglais « Transparent Conductive Oxide », qui est en l'occurrence en oxyde d'indium dopé à l'étain, abrégé ITO, en anglais « Indium Tin Oxide »). L'épaisseur optique de la cavité est modulée, soit par l'épaisseur de l'anode transparente, soit par un espaceur optique en silice qui est ajouté entre le miroir semi-transparent et la cathode.

Ce brevet pionnier a suscité plusieurs perfectionnements. A ce titre, JP 2003 142 277 A (Pioneer) décrit un dispositif de type « bottom émission » similaire, avec des émetteurs RGB structurés ; l'épaisseur de l'anode en ITO est différente selon la couleur du groupe de pixels, et l'interférence est déterminée par la position de l'émetteur par rapport au réflecteur.

US 6 639 250 B1 (Seiko Epson and Cambridge Display Technology) propose pour un dispositif de type émission par le bas (« bottom emission » en anglais) une approche similaire, qui utilise des miroirs diélectriques des deux côtés pour former la cavité optique. Chaque groupe de pixels RGB dispose de sa propre microcavité utilisant un système de multicouches diélectriques semi-transparentes, un système de multicouches réflectrices, et une couche diélectrique d'épaisseur ajustable (« gap adjustment layer ») située au-dessus de l'empilement OLED. Ce dispositif présente une structure multicouches d'une très grande complexité, et il n'est pas clair comment on peut structurer (pixeliser) la couche diélectrique ajustable et le système de multicouches réflectrices.

EP 1 450 419 B1 (Kodak) décrit des dispositifs de type « top émission » et « bottom émission » avec une structure dans laquelle la cavité optique est définie par deux miroirs métalliques. Un empilement OLED avec émission optique à spectre large est placé entre un réflecteur semi-transparent et une électrode réfléchissante, incluant une couche de modulation de phase transparente conductrice (appelée « phase layer », en TCO, par exemple ITO) qui permet la modulation de la cavité optique associée. Cette couche de modulation de phase est déposée par évaporation ou pulvérisation cathodique, puis structurée par des moyens de photolithographie conventionnelle afin de la laisser sur les pixels d'un groupe de pixels d'une couleur visée. Ensuite le procédé est réitéré avec une deuxième couche pour les pixels d'un groupe de pixels d'une autre couleur visée. Ainsi on peut réaliser avec deux séquences de photolithographie des groupes de pixels R, G et B : le groupe de pixels B n'a pas de couche de modulation de phase, le groupe de pixels G une, le groupe de pixels R deux. Pour les dispositifs de type émission par le bas on ajoute une couche de réduction d'absorption entre le substrat et l'électrode-semi-transparente.

Cette approche nécessite la gravure de plusieurs couches de TCO, ce qui est complexe. Par ailleurs, le contrôle de l'uniformité de l'épaisseur des couches TCO déposées par pulvérisation cathodique ou évaporation parait très difficile avec une précision compatible avec les exigences d'une cavité optique.

EP 1 672 962 B1 (Sony) décrit un dispositif de type émission par le haut similaire à celui du document précédent. L'électrode inférieure comprend trois couches de TCO : une couche de contact en ITO, une couche de résonance agissant comme réflecteur, et une autre couche dont l'épaisseur dépend de la couleur visée. Cette électrode est structurée (pixellisée) en faisant intervenir des procédés de la microélectronique. Le contrôle de l'épaisseur des couches de TCO est critique; cette couche peut être déposée par pulvérisation cathodique (avec un contrôle de l'épaisseur qui semble insuffisant) ou par ALD (Atomic Layer Déposition), une technique qui permet un contrôle très précis de l'épaisseur, mais qui n'offre qu'un choix de matériaux restreint (ZnO, AZO (oxyde de zinc dopé à l'aluminium) ou $SnO_2$). Cependant, le dépôt de la couche de TCO par ALD présente deux inconvénients spécifiques à cette structure : D'une part, étant donné que le TCO doit être déposé sur une résine photosensible, le dépôt par ALD, à cause de sa parfaite conformité, est déposé aussi sur les flancs verticaux de la résine, avec une tendance à créer des parois verticales qui résistent à l'enlèvement de la résine photosensible (appelée couramment « photorésist »). D'autre part, la gravure de couches déposées par ALD s'avère très critique : Certains types de TCO susceptibles d'être déposés par ALD comme le ZnO ou le AZO se gravent très facilement, par contre les couches sont attaquées en particulier pendant l'enlèvement (stripping) de la résine, donc un contrôle précis de leur épaisseur n'est pas possible. D'autres types de TCO comme le $SnO_2$ forment en revanche des couches très dures qui ne sont pas attaquées par le développeur de la résine photosensible, ni pendant le stripping, et elles sont très difficiles à graver.

Ce document décrit une variante qui évite les problèmes liés au dépôt du TCO sur résine photosensible, en utilisant trois matériaux différents et trois méthodes de gravures différentes pour chacune des trois couches de TCO, les matériaux étant choisis de manière à permettre une gravure sélective. Le procédé est alors très complexe, et le choix de matériaux est très limité.

US 2009/0283 786 (Seiko Epson) décrit une autre approche similaire à celle décrite dans EP 1 450 419. Le dispositif décrit un dispositif OLED avec une cavité optique d'épaisseur différente pour les groupes de pixels R, G, B, l'épaisseur de la cavité étant modulée par l'épaisseur d'une couche d'ITO ; la structuration de cette couche d'ITO n'est pas décrite. Une couche à bas indice de réfraction est déposée au-dessus de l'électrode supérieure pour améliorer la pureté de la couleur.

US 2012/022 9014 (Seiko Epson) décrit encore une autre approche, similaire à celle décrite dans EP 1 672 962 B1, avec une, deux ou trois couches de TCO selon la couleur du groupe de pixels. Pour éviter une différence de hauteur trop importante il est proposé de déposer une couche de lissage diélectrique. Le problème de cette structure est la faible ouverture optique des pixels. Le procédé de structuration de ces couches n'est pas décrit.

Une approche différente est proposée dans la demande de brevet US 2006/0138 945 (Samsung). La partie pixellisée de la cavité optique se trouve en dehors du dispositif OLED, au-dessus de l'électrode supérieure. Les espaceurs transparents d'une épaisseur choisie sont créés par une technique d'impression par transfert thermique. Cette technique ne semble pas être d'une fiabilité industrielle suffisante pour des pixels d'une taille de quelques micromètres ; par ailleurs on aimerait éviter de faire un dépôt au-dessus de l'empilement OLED par une technique qui implique une pression mécanique et/ou un échauffement significatif, car l'empilement OLED est assez fragile. Un autre inconvénient de cette approche réside dans l'absorption optique de l'électrode supérieure en TCO.

Encore une autre approche est décrite dans US 2012/0241 782 A1 (Sony). L'épaisseur de la cavité optique est modulée par une structuration d'une couche de transport de trous qui fait partie de l'empilement OLED. Cela ne résout pas le problème de la grande difficulté industrielle de structurer en pixels le dépôt des couches organiques formant l'empilement OLED pour une taille de pixels inférieure à une vingtaine de $\mu$m.

US 2016/0211 479 (Seiko Epson) introduit l'idée de moduler l'épaisseur des cavités optiques avec des couches transparentes diélectriques (telles que $SiO_2$ ou SiN) pixellisées. Plusieurs modes de réalisation pour la modulation de l'épaisseur sont décrits : on peut utiliser une couche de TCO (par exemple ITO), ou une couche diélectrique (telle que de la silice) disposée entre le réflecteur inférieur et l'électrode en ITO. Cependant, aucun procédé pour structurer cette couche de TCO et cette couche de diélectrique en groupes de pixels n'est décrit. Le dépôt d'une couche diélectrique nécessite en plus d'aménager des trous de contact avec l'électrode inférieure, ce qui complique le procédé de fabrication d'un tel dispositif.

Une réalisation plus concrète de cette idée est décrite dans US 2015/006 0811A1 (Seiko Epson) pour une structure avec une couche transparente ($SiO_2$ ou SiN) dans une structure réflecteur / espaceur / électrode transparente (ITO) / empilement OLED I électrode semi-transparente. On note que l'ITO a une absorbance optique non négligeable. US 9 972 804B2 (Seiko Epson) donne une autre variante de ce concept.

A titre d'alternative, le document US 2016/0211 479 précité propose de moduler l'épaisseur de la couche d'injection de trous de l'empilement OLED; cela pose de nouveau le problème de la structuration de cette couche en pixels de taille inférieure à une vingtaine de $\mu$m.

On constate que l'état de la technique n'offre pas de solution satisfaisante pour générer les couleurs primaires RGB par interférence à partir d'un empilement OLED blanc commun aux pixels RGB. Le même problème se pose pour d'autres dispositifs optoélectroniques, tel que des capteurs optiques dont la couche photosensible est un empilement OLED ; un tel dispositif est décrit dans WO 2017/029 223 (Technische Universität Dresden). EP 3 671 849 (Commissariat à l'énergie atomique et aux énergies alternatives) décrit un dispositif dans lequel des espaceurs optiques sont réalisés pour chaque couleur de pixel à l'aide de bicouches en différents oxydes transparents. Ce procédé comporte une succession complexe d'étapes de gravure humide visant à l'enlèvement sélectif de couches d'oxydes transparentes.

Le but de la présente invention est de proposer un dispositif optoélectronique, notamment un micro-afficheur OLED, qui présente des groupes de pixels pour les couleurs primaires RGB de très petite taille (de l'ordre de 3 $\mu$m à 5 $\mu$m) à partir d'un empilement OLED d'émission blanche commun, de préférence en géométrie type émission par le haut (« top-emission » en anglais). Ce dispositif doit présenter une bonne efficacité optique, une excellente durabilité, et doit pouvoir être fabriqué avec un procédé industriel fiable qui présente un bon rendement industriel, et qui permet d'obtenir un bon contrôle dimensionnel des pixels, une bonne homogénéité des épaisseurs optiques au travers du pixel ainsi qu'une bonne homogénéité au travers du substrat.

## Objets de l'invention

Selon l'invention le problème est résolu par un dispositif optoélectronique qui présente des pixels, dans lequel un empilement photoactif de couches est disposé entre les deux réflecteurs d'une cavité optique, et dans lequel l'épaisseur optique de ladite cavité optique est modulée à l'échelle du pixel. Une telle structure permet la génération (dans le cas d'un dispositif émissif) ou la détection (dans le cas d'un dispositif de détection) de lumière d'une couleur donnée à l'intérieur de la cavité optique, ladite couleur étant déterminée par la longueur optique de la cavité spectrale.

Ledit dispositif optoélectronique comprend donc une pluralité de groupes de pixels qui se distinguent par la longueur optique de leur cavité optique. Selon une caractéristique essentielle de l'invention, la cavité optique comprend, pour au moins un des groupes de pixels, une bicouche formée par deux couches transparentes et conductrice différentes, qui se distinguent par leur résistance à un traitement de gravure humide (qui présentent, autrement dit, une vitesse de gravure différente par rapport à un bain liquide) ; cela permet au cours du procédé de fabrication du dispositif la gravure humide sélective de celle des deux couches qui présente la visse de gravure la plus élevée.

Plus précisément, chacune desdites bicouches est formée d'une première couche transparente et conductrice d'un premier matériau transparent et conducteur, et d'une deuxième couche transparente et conductrice d'un deuxième matériau transparent et conducteur, en contact direct avec ladite première couche transparente et conductrice, ledit premier matériau étant différent dudit deuxième matériau. Pour chacune de ces bicouches ladite première couche conductrice et transparente, comptée à partir du substrat du dispositif optoélectronique, présente une résistance plus faible à un traitement de gravure humide que ladite deuxième couche conductrice et transparente.

Un premier objet de l'invention est un dispositif optoélectronique comprenant un substrat et un empilement de couches organiques comprenant au moins une couche active pouvant être une couche émettrice de lumière ou une photodiode, disposée entre une surface réfléchissante, ou entre la surface d'une couche transparente déposée directement sur ladite surface réfléchissante, et une surface semi-transparente et semi-réfléchissante disposées face à face à une distance donnée et formant une cavité optique d'une longueur optique $d$ donnée,

et ledit dispositif étant caractérisé en ce qu'il comprend au moins trois groupes de pixels dont chaque groupe est caractérisé par une cavité de longueur optique différente, ladite cavité comprenant un nombre de bicouches disposées entre ledit substrat et ledit empilement de couches organiques, chaque bicouche étant formée d'une première couche transparente et conductrice d'un premier matériau transparent et conducteur, et d'une deuxième couche transparente et conductrice d'un deuxième matériau transparent et conducteur, en contact direct avec ladite première couche transparente et conductrice, ledit premier matériau étant différent dudit deuxième matériau, et ledit dispositif étant caractérisé en ce que :

pour un premier groupe de pixels le nombre de bicouches est de zéro ;
pour un deuxième groupe de pixels, le nombre de bicouches est de un,
pour un troisième groupe de pixels, le nombre de bicouches est de deux ou de un, mais dans ce dernier cas, ladite première couche de la bicouche associé au troisième groupe de pixels est plus épaisse que celle du deuxième groupe de pixels,
pour chaque groupe additionnel de pixels, si présent, le nombre de bicouches augmente de un par rapport au groupe précédent ou reste le même, mais dans ce dernier cas, ladite première couche de la bicouche associée au groupe additionnel de pixels est plus épaisse que celle du précédent groupe de pixels,
sachant que le comptage des groupes en premier, deuxième, troisième et, le cas échéant, ainsi de suite, suit un ordre de la valeur de $d$ croissant ;
et ledit dispositif étant caractérisé en ce que pour chacune de ces bicouches ladite première couche conductrice et transparente, comptée à partir dudit substrat, présente une résistance plus faible à un traitement de gravure humide que ladite deuxième couche conductrice et transparente. Pour chaque groupe de pixels au-delà du premier, au moins ladite première couche de la bicouche la plus éloignée du substrat est protégée latéralement par ladite deuxième couche de bicouche.

Dans un mode de réalisation, pour chaque groupe de pixels au-delà du premier, ladite première couche de la bicouche la plus éloignée du substrat est totalement encapsulée par ladite deuxième couche de la bicouche.

Dans un autre mode de réalisation, compatible avec le précédent, pour chaque groupe de pixels au-delà du premier, ladite première couche de toutes les bicouches est totalement encapsulée par une couche d'un deuxième matériau transparent et conducteur.

Ladite surface réfléchissante peut être couverte d'une couche dudit deuxième matériau transparent et conducteur; cette couche ne sera alors pas prise en compte dans le comptage des couches formant une bicouche.

Ledit traitement de gravure humide est un traitement avec une solution aqueuse d'hydroxyde de tétraméthylammonium à 2,38 % massiques à température ambiante.

Dans un mode de réalisation très avantageux, dans chacune desdites bicouches, ladite première couche transparente et conductrice présente une vitesse de gravure spécifique V1 qui au moins dix fois supérieure, de préférence au moins cent fois supérieure, et encore plus préférentiellement au moins mille fois supérieure que la vitesse de gravure spécifique V2 de ladite deuxième couche transparente.

Lesdits matériaux transparent et conducteurs sont typiquement des oxydes d'au moins un élément métallique (TCO - Transparent Conductive Oxide). Ledit premier matériau transparent et conducteur (appelé ici aussi « TCO doux ») peut être sélectionné dans le groupe formé par : le ZnO ; les oxydes dopés à base de ZnO, le dopage étant de préférence au gallium et /ou à l'aluminium et/ou au bore et/ou au béryllium ; l'oxyde d'indium ; les oxydes dopés à base d'oxyde d'indium, le dopage étant de préférence à l'étain. Ledit deuxième matériau transparent et conducteur (appelé ici aussi « TCO dur ») peut être sélectionné dans le groupe formé par : le $SnO_2$, le $SnO_2$ dopé, ce dopage étant de préférence à l'arsenic et/ou au fluore et/ou à l'azote et/ou au niobium et/ou au phosphore et/ou à l'antimoine et/ou à l'aluminium et/ou au titane.

Selon un mode de réalisation avantageux, ledit empilement de couches organiques est en contact direct avec, d'une part, ladite surface réfléchissante ou une couche transparente déposée sur ladite surface réfléchissante, et/ou, d'autre part, avec ladite surface semi-réfléchissante.

Ledit empilement de couches organique forme un revêtement continu sur l'ensemble des pixels. Typiquement, une couche semi-transparente et conductrice est déposée au-dessus dudit empilement de couches organiques ; elle agit comme électrode supérieure. Ledit empilement de couches organiques, et de préférence aussi ladite couche semi-transparente en conductrice, forment chacune un revêtement continu sur l'ensemble des pixels. L'adressage individuel des pixels peut se faire alors par l'intermédiaire de l'électrode inférieure, qui est structurée au niveau du pixel (« pixellisée »). Ledit substrat du dispositif optoélectronique est avantageusement un substrat de type CMOS, pourvu de circuits permettant un adressage ou une lecture individuel des pixels.

Le Dispositif optoélectronique selon l'invention peut être réalisé sous la forme d'un dispositif émissif, qui est typiquement micro-afficheur OLED, dans lequel l'empilement organique comprend une couche électroluminescente, ou sous la forme dispositif de détection, qui est typiquement un capteur de lumière multi-spectral. Dans ce dernier cas l'empilement organique comprend une photodiode, de type OPD (pour Organic Photodetector en langue anglaise).

Un autre objet de la présente invention est un procédé de fabrication pour un dispositif optoélectronique selon l'invention, dans lequel :

on dépose d'abord une première couche transparente et conductrice d'un premier matériau transparent et conducteur sur ladite première surface réfléchissante ou sur une couche transparente et conductrice d'un deuxième matériau déposée sur ladite première surface réfléchissante ;

on dépose un premier masque qui délimite un deuxième et un troisième groupe de pixels et protège leur emplacements ;

on enlève par gravure humide ladite première couche transparente et conductrice aux endroits non protégés par ledit premier masque, ces endroits non protégés comprenant l'emplacement prévu pour un premier groupe de pixels, et on enlève ledit premier masque ;

on dépose une première couche transparente et conductrice d'un deuxième matériau transparent,

on dépose une deuxième couche transparente et conductrice d'un premier matériau transparent et conducteur ;

on dépose un deuxième masque qui délimite ledit troisième groupe de pixels et protège leurs emplacements ;

on enlève par gravure humide ladite couche transparente et conductrice d'un premier matériau transparent et conducteur aux endroits non protégés par ledit deuxième masque, ces endroits non protégés comprenant l'emplacement prévu pour ledit deuxième et ledit premier groupe de pixels, et on enlève ledit deuxième masque ;

on dépose une deuxième couche transparente et conductrice d'un deuxième matériau transparent et conducteur ;

on dépose un troisième masque qui délimite lesdits premier, deuxième et troisième groupe de pixels et protège leur emplacement ;

on enlève par gravure sèche lesdites première et deuxième couche d'un deuxième matériau transparent et conducteur ainsi que ladite couche réfléchissante et, si elle est présente, ladite couche dudit deuxième matériau transparent et conducteur la recouvrant aux endroits non protégés par ledit troisième masque.

Dans un tel procédé de fabrication pour un dispositif optoélectronique avec trois groupes de pixels, on peut poursuivre le procédé par les étapes suivantes:

on dépose un élément de remplissage dans chaque espace entre deux pixels voisins ;

on dépose un empilement de couches organiques commun à tous les pixels, on dépose au-dessus dudit empilement de couches organiques une couche électrode semi-réfléchissante, commune à tous les pixels.

Avantageusement, le dépôt des couches transparentes et conductrices dudit deuxième matériau transparent et conducteur est effectué par la technique de dépôt de couches atomiques.

Le dépôt des masques se fait par le dépôt d'une résine photosensible, selon des techniques micro-lithographiques connues de l'homme du métier.

**Brève description des figures**

Les figures 1 à 19 illustrent à titre de comparaison un mode de réalisation d'un procédé et dispositif qui ne fait pas partie de l'état de la technique, mais qui ne résout pas le problème posé. Les figures 1 à 6 représentent de manière schématique une coupe transversale à travers un dispositif optoélectronique à différents stades de sa fabrication ; ce dispositif présente trois groupe de pixels.

Les figures 20 à 42 illustrent certains aspects du procédé et dispositif selon l'invention.

Elles représentent de manière schématique une coupe transversale à travers des dispositifs optoélectroniques selon l'invention à différents stades de leur fabrication.

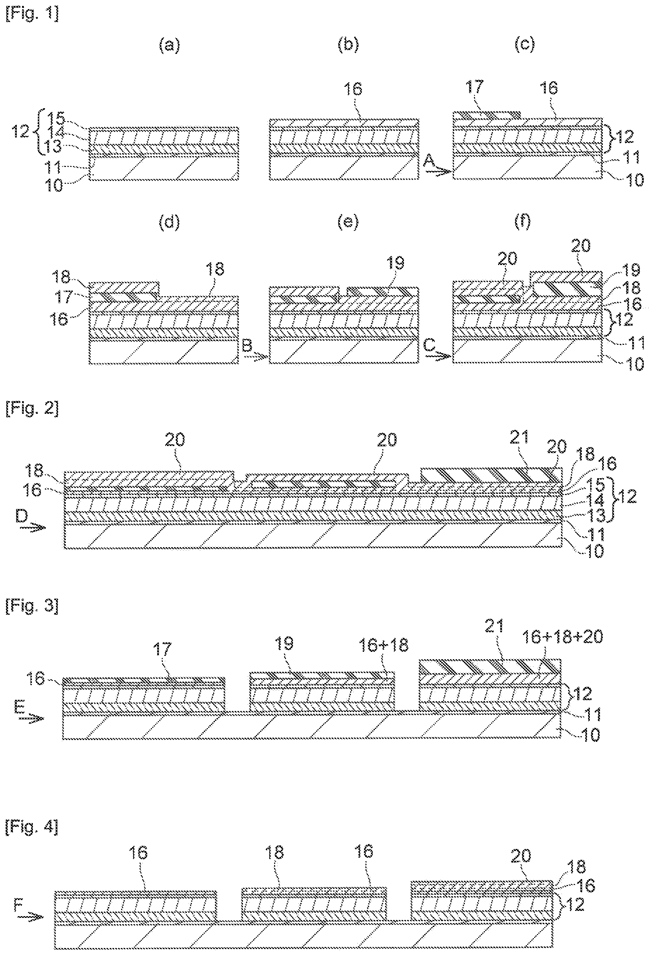

La figure 1 illustre en six épisodes une première séquence d'étapes d'un procédé pour fabriquer un dispositif de type micro-afficheur OLED présentant trois groupes de pixels.

La figure 2 illustre une deuxième séquence d'étapes de procédé qui fait suite à celles de la figure 1.

La figure 3 illustre une troisième séquence d'étapes de procédé qui fait suite à celles de la figure 2.

La figure 4 illustre une quatrième séquence d'étapes de procédé qui fait suite à celles de la figure 3.

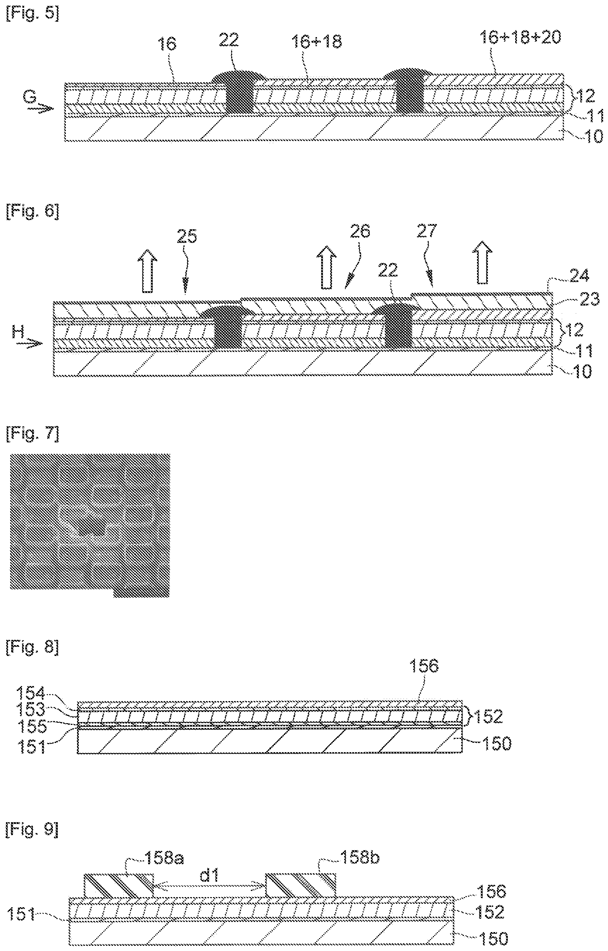

La figure 5 illustre une cinquième séquence d'étapes de procédé qui fait suite à celles de la figure 4.

La figure 6 illustre une sixième séquence d'étapes de procédé qui fait suite à celles de la figure 5.

La figure 7 représente une micrographie électronique à balayage d'un dispositif qui représente l'étape à l'issue de la figure 4. La largeur de chaque pixel est de l'ordre de 4,5 μm.

La figure 8 illustre une première séquence d'étapes d'un procédé selon l'invention pour fabriquer un dispositif de type micro-afficheur OLED présentant deux groupes de pixels.

La figure 9 illustre une deuxième séquence d'étapes de procédé qui fait suite à celles de la figure 8.

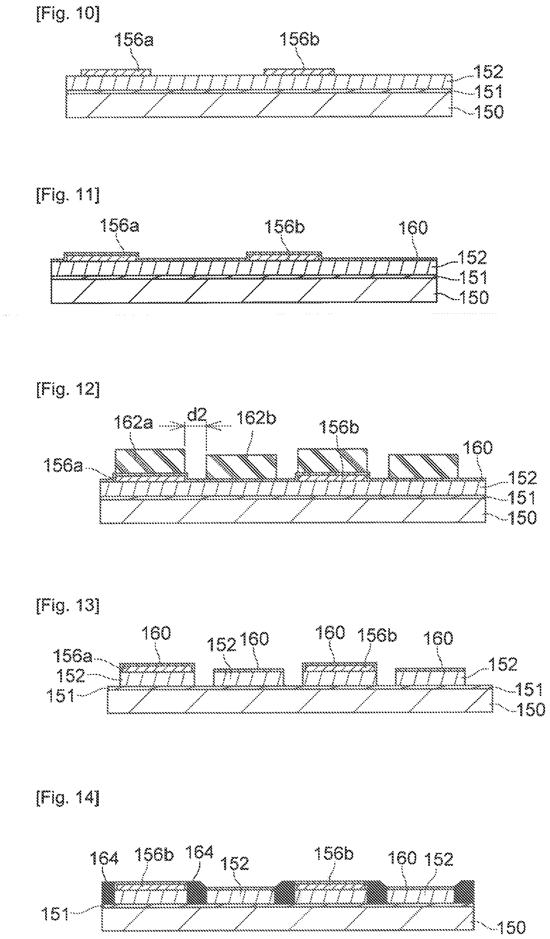

La figure 10 illustre une troisième séquence d'étapes de procédé qui fait suite à celles de la figure 9.
La figure 10 illustre une quatrième séquence d'étapes de procédé qui fait suite à celles de la figure 10.
La figure 12 illustre une cinquième séquence d'étapes de procédé qui fait suite à celles de la figure 11.
La figure 13 illustre une sixième séquence d'étapes de procédé qui fait suite à celles de la figure 12.
La figure 14 illustre une septième séquence d'étapes de procédé qui fait suite à celles de la figure 13.

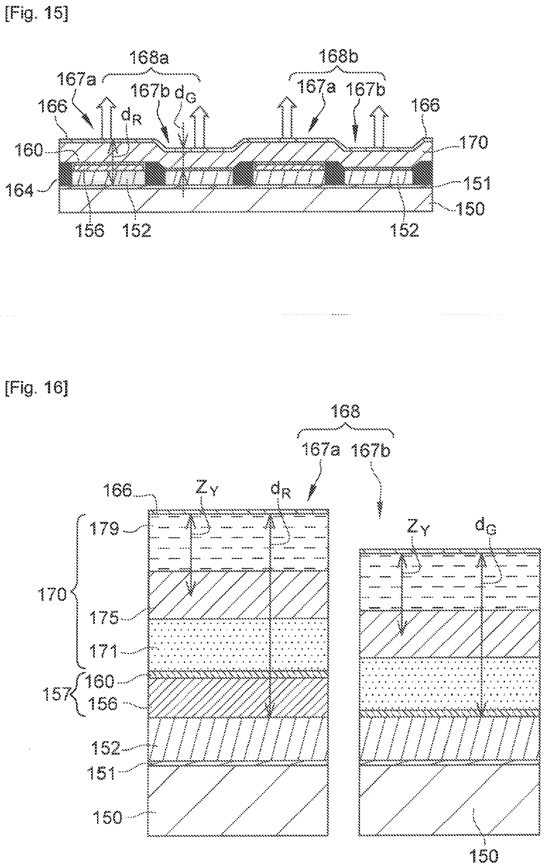

La figure 15 illustre une huitième séquence d'étapes de procédé qui fait suite à celles de la figure 14.
La figure 16 illustre une vue plus détaillée de l'empilement des couches organiques d'un dispositif de type micro-afficheur OLED similaire à celui présenté sur les figures 8 à 15.

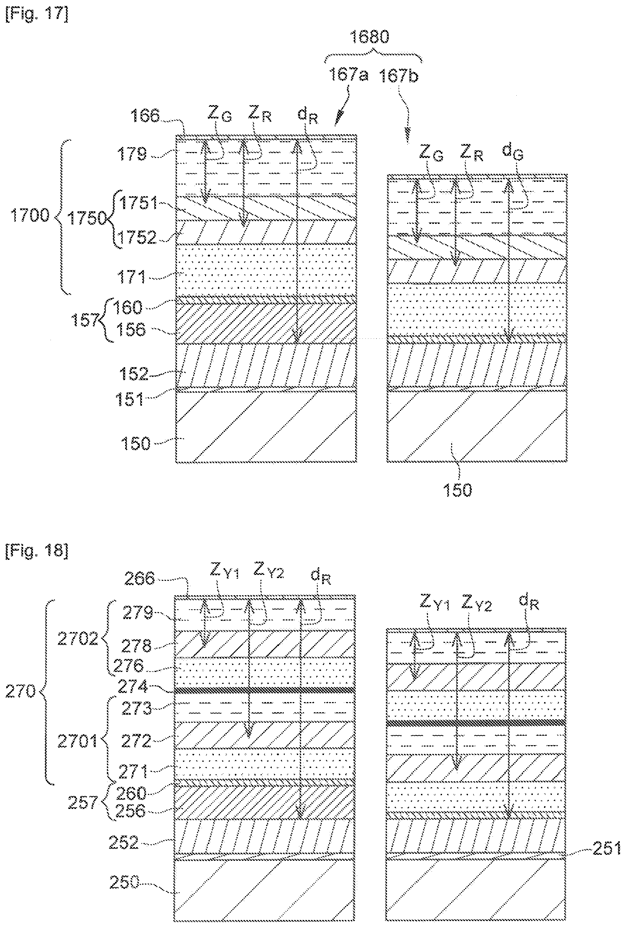

La figure 17 illustre une variante du dispositif montré sur la figure 16.
La figure 18 illustre une autre variante du dispositif montré sur la figure 16.

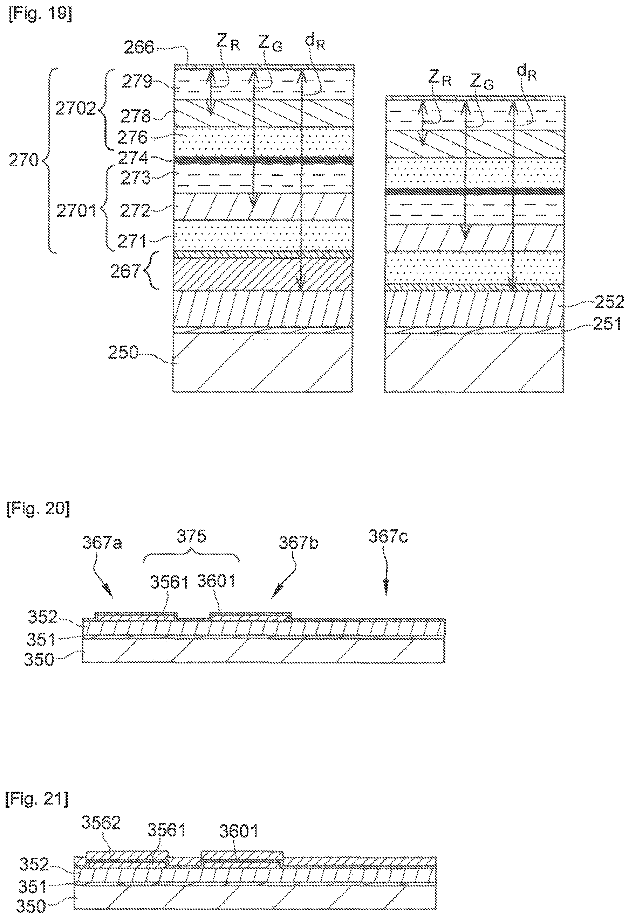

La figure 19 illustre encore une autre variante du dispositif montré sur la figure 16.
La figure 20 illustre une première séquence d'étapes d'un mode de réalisation du procédé selon l'invention pour fabriquer un dispositif de type micro-afficheur OLED selon l'invention, présentant trois groupes de pixels.
La figure 21 illustre une deuxième séquence d'étapes de procédé qui fait suite à celles de la figure 20.

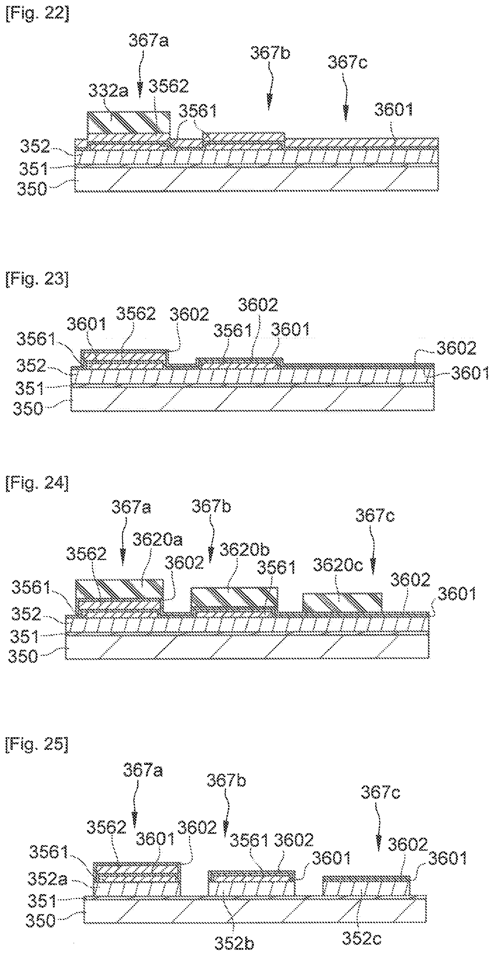

La figure 22 illustre une troisième séquence d'étapes de procédé qui fait suite à celles de la figure 21.
La figure 23 illustre une quatrième séquence d'étapes de procédé qui fait suite à celles de la figure 22.
La figure 24 illustre une cinquième séquence d'étapes de procédé qui fait suite à celles de la figure 23.
La figure 25 illustre une sixième séquence d'étapes de procédé qui fait suite à celles de la figure 24.

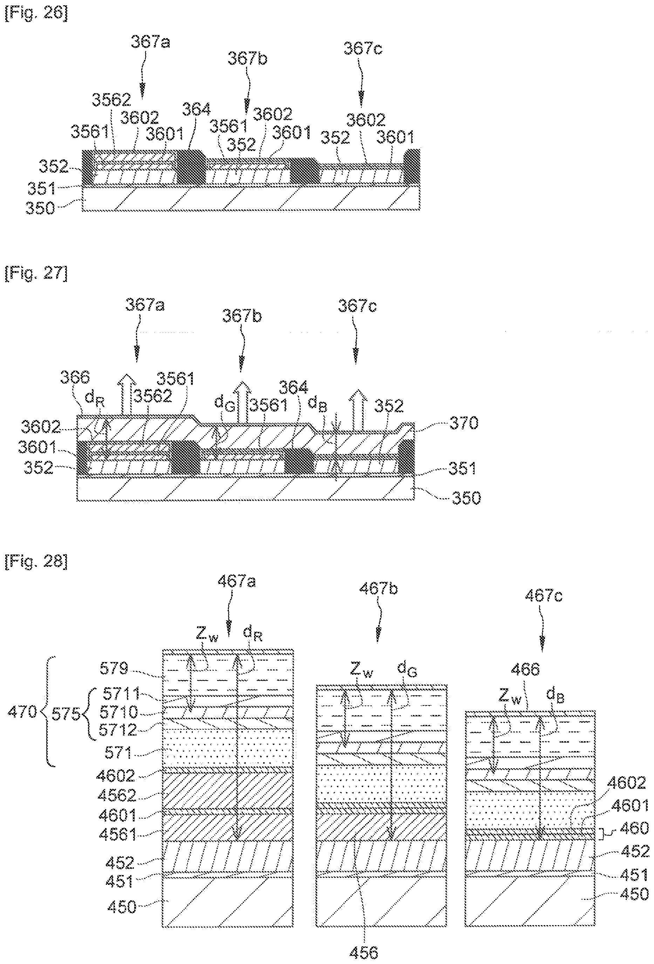

La figure 26 illustre une septième séquence d'étapes de procédé qui fait suite à celles de la figure 25.
La figure 27 illustre une huitième séquence d'étapes de procédé qui fait suite à celles de la figure 28.
La figure 28 illustre une vue plus détaillée de l'empilement des couches organiques d'un dispositif de type micro-afficheur OLED selon l'invention, similaire à celui présenté sur les figures 20 à 27.

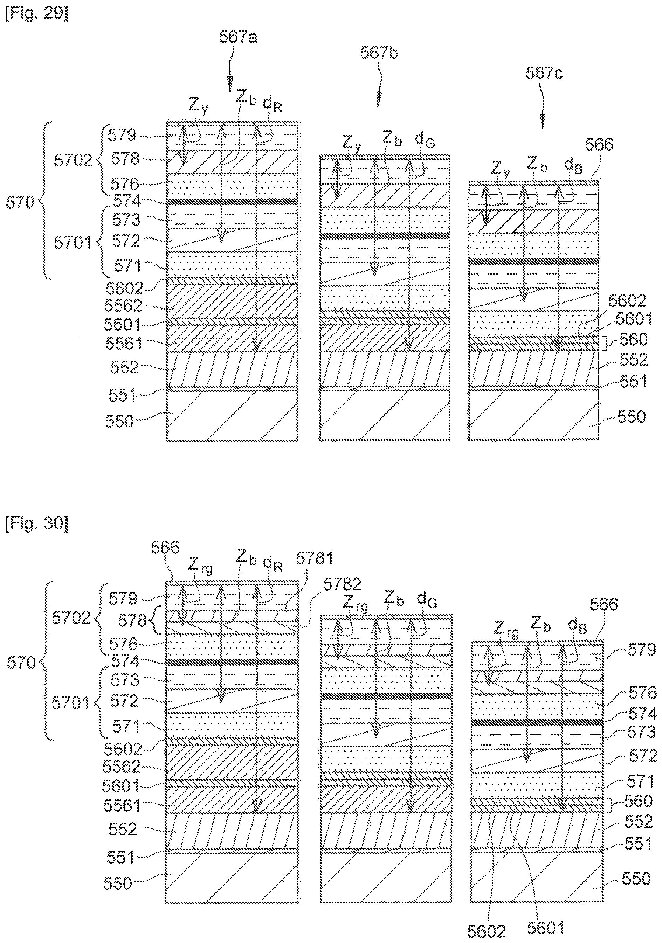

La figure 29 illustre une variante du dispositif montré sur la figure 28.
La figure 30 illustre une autre variante du dispositif montré sur la figure 28.

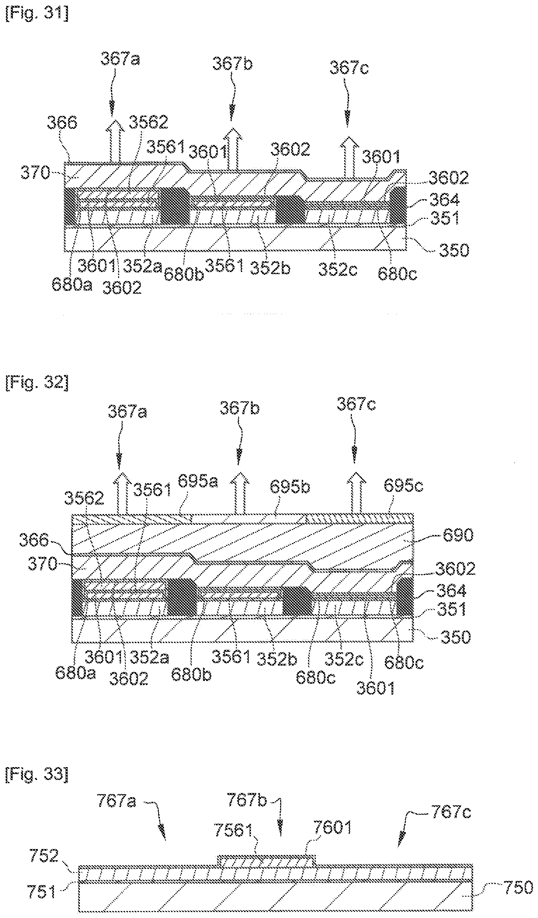

La figure 31 illustre une autre variante du dispositif montré sur la figure 27.
La figure 32 illustre encore une autre variante du dispositif montré sur la figure 27.
La figure 33 illustre une première séquence d'étapes d'un autre mode de réalisation du procédé selon l'invention pour fabriquer un dispositif de type micro-afficheur OLED selon l'invention, présentant trois groupes de pixels.

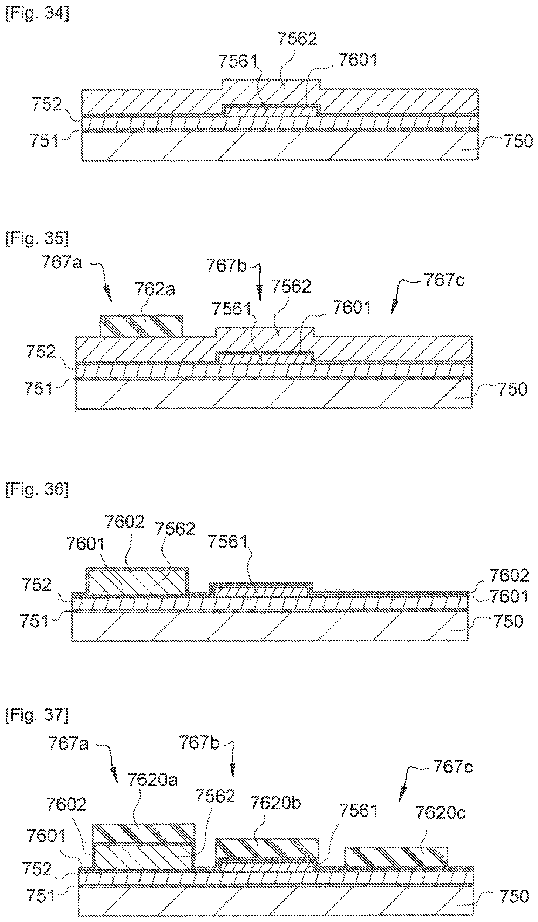

La figure 34 illustre une deuxième séquence d'étapes de procédé qui fait suite à celles de la figure 33.
La figure 35 illustre une troisième séquence d'étapes de procédé qui fait suite à celles de la figure 34.
La figure 36 illustre une quatrième séquence d'étapes de procédé qui fait suite à celles de la figure 35.
La figure 37 illustre une cinquième séquence d'étapes de procédé qui fait suite à celles de la figure 36.

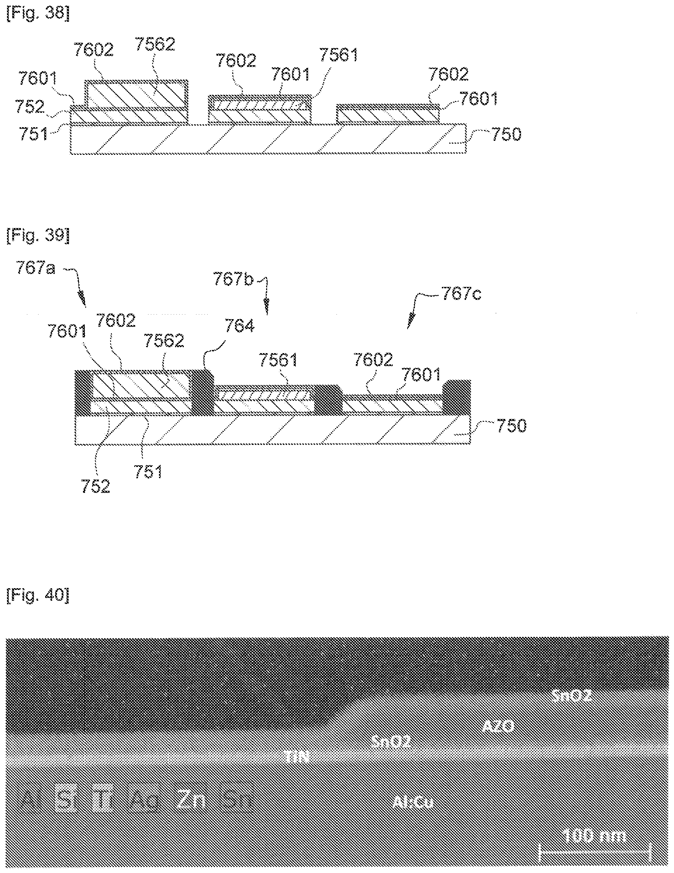

La figure 38 illustre une sixième séquence d'étapes de procédé qui fait suite à celles de la figure 37.
La figure 39 illustre une septième séquence d'étapes de procédé qui fait suite à celles de la figure 38.
La figure 40 montre une micrographie de microscopie électronique à balayage d'une coupe à travers un dispositif selon un mode de réalisation de l'invention se trouvant à un stade Intermédiaire de fabrication.

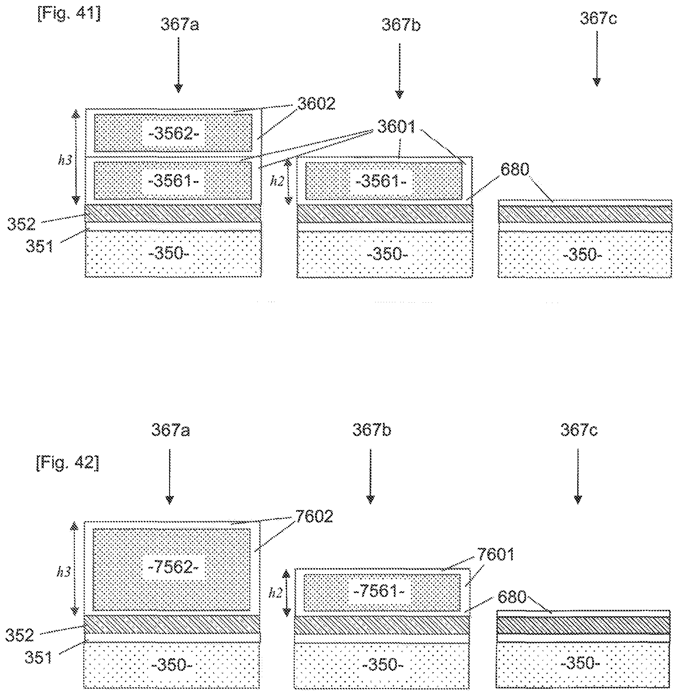

La figure 41 illustre une variante d'un dispositif selon l'invention.
La figure 42 illustre une autre variante d'un dispositif selon l'invention remplissant la même fonction que celui de la figure 41, mais avec une structure différente.

Les signes de références suivants sont utilisés sur les figures et dans la description :

| | |
|---|---|
| 10 | Substrat (typiquement de type CMOS) |
| 11 | Isolant (nitrure et/ou oxyde de silicium) |
| 12 | Electrode inférieure |
| 13 | Première couche (inférieure) de nitrure de titane (TiN) |
| 14 | Couche d'aluminium |
| 15 | Deuxième couche (supérieure) de nitrure de titane (TiN) |
| 16,18,20 | Première, deuxième, troisième couche de TCO |
| 17,19,21 | Première, deuxième, troisième couche de résine photosensible |
| 22 | Résine photosensible de remplissage (« gap fill ») |
| 23 | Empilement OLED |
| 24 | Electrode commune semi-transparente |
| 25,26,27 | Pixel |
| 150,350,450,550,750 | Substrat (typiquement de type CMOS), incluant des circuits de commande des ou pixels, dans le cas d'un dispositif OLED, ou de lecture dans le cas d'un dispositif capteur |

| | |
|---|---|
| 151,351,451,551,751 | Isolant (typiquement nitrure et/ou oxyde de silicium) |
| 152,352,452,552,752 | Electrode inférieure |
| 153 | Couche métallique de 152 |
| 154 | Deuxième couche (supérieure) de nitrure de titane 152 |
| 155 | Première couche (inférieure) de nitrure de titane 152 |
| 156,456 | Première couche de TCO (TCO dit « doux ») |
| 157,257 | Couches de TCO 156,160 formant espaceur optique |
| 158 | Résine photosensible (photerésist) |
| 160,360,460,560 | Deuxième couche de TCO (TCO dit « dur ») |
| 162,382,3620,762,7620 | Résine photosensible (photorésist) |
| 164,364,764 | Elément de remplissage entre pixels (« gap-fill ») |
| 166,266,366,466 | Electrode supérieure |
| 167,367,467,567,767 | Pixel |
| 168,1680 | Groupe de pixels |
| 170,1700,270,370,470 | Empilement OLED |
| 171,175,179 | Premier, deuxième et troisième ensemble de 170 |
| 1751,1752,572 | Couches émettrices d'un empilement OLED |
| 2701,2702 | 1er et 2ème ensemble d'un empilement OLED tandem |
| 271,276 ; 571 | Premier ensemble de couches de 270 et de 570 |
| 272,278 ; 575 | Deuxième ensemble de couches de 270 et de 570 |
| 273,279 ; 579 | Troisième ensemble de couches de 270 et de 570 |
| 27,574 | Couche de génération de charges |
| 3561,3562;4561,4562;5561,5562 ;7561,7562 | Première couche de TCO (doux) |
| 3601,3602;4601,4602;5601,5602 ;7601,7602 | Deuxième couche de TCO (dur) |
| 570 | Empilement OLED tandem |
| 5701,5702 | 1er et 2ème empilement de couches d'un empilement OLED tandem 570 |
| 5710,5711,5712 | Couches émettrices d'un empilement OLED |
| 5781,5782 | 1ère et 2ème couche émissive d'un empilement OLED |
| 680 | Couche de TCO (dur) dite de base |
| 690 | Couche de lissage |
| 695 | Filtre de couleur |

## Description détaillée

### Tentatives infructueuses de résoudre le problème posé

Les inventeurs se sont rendus compte que les solutions basées sur l'utilisation de couches diélectriques structurées comme espaceurs optiques nécessitent des procédés complexes, tels que la réalisation des vias conductrices (en électronique, dans un circuit intégré, un via est un trou métallisé au travers d'une couche isolante qui permet d'établir une liaison électrique entre deux niveaux de métal) ou le recours à des procédés de type transfert thermique. Pour la même raison, les inventeurs ont écarté l'utilisation des éléments de type multicouche diélectrique.

Les inventeurs ont essayé de prendre comme point de départ les solutions basées sur l'utilisation des couches transparentes conducteurs (TCO, par exemple ITO, ZnO, SnOz) comme espaceur optique, comme décrits notamment dans le document EP 1 450 419 cité ci-dessus. Cependant, la réalisation pratique de la structure décrite dans ce document s'est avérée difficile, pour plusieurs raisons :

Premièrement, pour pouvoir garantir des couleurs primaires stables au travers du substrat (qui est typiquement une tranche de silicium d'un diamètre de 200 mm ou de 300 mm, avec des circuits préparés par la technologie CMOS qui sont configurés pour adresser les pixels), il faut une très bonne uniformité de l'épaisseur des cavités optiques, de l'ordre de 98 % à 99%, qui est difficilement atteignable avec des méthodes des dépôt tel que décrites l'état de la technique, comme la pulvérisation cathodique ou le dépôt chimique à partir de vapeurs (CVD, i.e. Chemical Vapor Déposition, ou PECVD, i.e. Plasma Enhanced Chemical Vapor Déposition). Par contre, l'utilisation de la technique ALD (Atomic Layer Déposition) permet d'obtenir une telle homogénéité de l'épaisseur. Cependant, elle ne peut être appliquée qu'à un nombre limité de matériaux TCO, tels que le ZnO, le AZO (qui est une variante plus conductrice du ZnO), ainsi que le $SnO_2$.

Deuxièmement, la réalisation de trois couches de TCO structurées pour former des groupes de pixels avec trois épaisseurs optiques différentes s'avère assez difficile. Comme indiqué ci-dessus, EP 1 672 962 comporte la description détaillée d'un procédé basé sur trois étapes de dépôt et de photolithographie de résine, une gravure et un stripping de ces trois couches de résine. Avec quelques ajouts et modifications, on peut traduire cela dans un schéma de procédé représenté sur la figure 1 par les images 1(a) à 1(f).

Le point de départ est un substrat de type CMOS (par exemple sur une tranche de silicium), avec en dernier niveau le métal pour former les pixels, ici de l'aluminium revêtu d'une fine couche de TiN comme protection contre l'oxydation.

Dans une première séquence d'étapes illustrée sur la figure 1, on a pris comme point de départ (état (a)) un substrat de type CMOS **10** revêtu d'une couche de $Si_3N_4$ ou de $SiO_2$ **11** (environ 200 nm) et d'une couche de base d'électrode **12** réfléchissante; ladite électrode de base comportait une couche d'aluminium (environ 200 nm) prise en sandwich entre une première couche de TiN **13** (environ 50 nm), inférieure, et une deuxième couche de TiN **15** (environ 7 nm), supérieure.

Sur la deuxième couche de TiN **15** on a déposé successivement trois couches de TCO **16,18,20** (AZO ou ZnO) par ALD (états(b),(d), (f)), avec intercalage du dépôt et de la lithographie (états (c),(e)) de trois couches **17,19,21** de résines photosensibles (plus couramment appelée « photorésist »), afin de réaliser les trois groupes de pixels (R, G et B). La figure 2 montre le résultat après la troisième étape de photolithographie.

On note que la figure 1 ne montre, dans un souci de simplification, que deux pixels appartenant chacun à un groupe différent, alors que les figures 3 à 6 montrent effectivement les trois groupes de pixels.

Dans une deuxième séquence d'étapes illustrée sur les figures 3 et 4, on a procédé à la gravure sèche de toutes les couches incluant l'électrode réfléchissante **12,** en utilisant les trois couches de résine photosensible (photorésist) **17,19,21** comme masque afin de graver les couches TCO **16,18,20** selon la nature du pixel et afin de séparer les pixels ; cela est Illustré sur la figure 3. On a ensuite décapé la résine photosensible par un procédé connu sous la désignation « stripping humide » (figure 4).

Dans une troisième séquence d'étapes illustré sur la figure 5, on a déposé et délimité par lithographie une résine photosensible **22** pour remplir l'espace entre les pixels et pour planariser la surface.

Dans une quatrième séquence d'étapes illustrées sur la figure 6 on a déposé un empilement **OLED 23** à émission blanche avec une électrode commune **24** semi-transparente en haut. Les épaisseurs et les positions des émetteurs étaient optimisés afin de réaliser des cavités optiques pour d'extraire des primaires R, G, B avec une efficacité optimum. On obtient ainsi trois groupes de pixels **25,26,27** R,G,B, adressables individuellement par l'intermédiaire des circuits qui font partie du substrat CMOS ; ces circuits ainsi que la manière d'établir le contact entre eux et l'électrode inférieure des pixels **12** sont connus, ne font pas partie de l'invention et ne seront pas précisés ici.

On a trouvé trouve que ce procédé n'est pas utilisable en production Industrielle, pour trois raisons.

Tout d'abord, le contrôle de l'épaisseur final des couches TCO n'est pas satisfaisant. Bien que le dépôt par ALD permette de contrôler l'épaisseur des couches TCO avec une précision de 1% - 2%, et conduise à une très bonne uniformité sur la superficie du substrat, cette épaisseur est réduite pendant le procédé de structuration. C'est en particulier l'étape de décapage (stripping) de la résine photosensible (i.e. l'étape qui conduit à la structure montrée sur la figure 4) qui attaque la couche TCO d'une façon difficilement contrôlable. En fait, le procédé de gravure sèche (RIE ou IBE) durcit la résine photosensible, qui nécessite alors un décapage humide assez puissant afin de pouvoir enlever la résine ; ce décapage humide attaque aussi le TCO.

Ensuite, on observe que le bord du pixel est dégradé. En effet, pendant l'étape qui mène de l'état (c) à l'état (d) de la figure 1, et pendant l'étape qui mène de l'état e) de la figure 1 à l'état f, le dépôt du TCO se fait en partie sur les flancs verticaux des plots de résine photosensible **17** et **19**. Comme le dépôt par ALD est parfaitement conforme, cela conduit à une formation de parois verticales en TCO qui résistent en partie au stripping de la résine photosensible. Cela est visible sur la figure 7 qui représente une micrographie électronique à balayage : on voit clairement des boites rectangulaires avec des parois verticales de TCO, alors que l'intérieur des boîtes est vide ; chacune de ces boites représente un pixel. Pour enlever ces parois verticales, une gravure humide supplémentaire est nécessaire, qui dégrade l'uniformité du TCO au bord du pixel. Cela nuit aux caractéristiques optiques des pixels, et plus généralement à la fiabilité du dispositif optoélectronique.

Et enfin, on observe que la caractéristique du pixel OLED est dégradée. Par rapport à une utilisation du métal de pixel d'origine (Al/TiN), on trouve que la tension d'opération de l'OLED (déposé sur la structure avec des couches TCO structurés) est augmentée de 1V à 2 V, ce qui dû à une mauvaise injection des porteurs (trous) de la couche TCO dans l'OLED.

Afin d'améliorer le contrôle d'épaisseur, on a utilisé un autre type de TCO, en occurrence le $SnO_2$ qui s'est révélé être significativement plus résistant au décapage humide que les TCO de type ZnO ou AZO. Un autre avantage du $SnO_2$ est qu'il ne dégrade pas les caractéristiques des empilements OLED. En revanche, les inventeurs n'ont pas été en mesure de trouver une méthode de gravure humide permettant d'enlever complètement les parois verticales crées pendant le procédé de dépôt ALD. Par conséquent, cette approche nouvelle ne permet pas de résoudre le problème posé : cette combinaison des enseignements des documents EP 1 450 419 et EP 1 672 962 conduit dans impasse.

Description de certains modes de réalisation de l'invention

On retient de l'expérience décrit ci-dessus que pour développer un procédé qui permet un bon contrôle de l'épaisseur finale et une bonne homogénéité du pixel sans dégradation du bord il faut modifier la structure du dispositif. On retient par ailleurs qu'il faut éviter des dépôts de TCO par ALD sur la résine photosensible, car cela engendre la formation de parois verticales au bord du pixel, et qu'il faut éviter de durcir la résine photosensiblet par une gravure sèche, ce qui le rend très résistant au décapage.

Selon une caractéristique essentielle de la présente invention, on utilise comme espaceur optique un empilement d'au moins deux couches de TCO différents, qui se distinguent par leur résistance à la gravure, notamment à la gravure humide : le TCO dit « dur » est plus résistant à la gravure que le TCO dit « doux ».

Les TCO doux, parmi lesquels se trouvent notamment le ZnO et l'AZO, se gravent très bien en gravure humide avec ensuite un décapage sec (stripping sec) de la résine photosensible, par exemple au plasma $O_2$, et cela n'impacte pas leur épaisseur. Par contre, il faut les protéger pendant l'étape de gravure sèche pour séparer les pixels, et pendant le décapage (stripping) humide de la résine photosensible. On note que leur utilisation comme anode pour l'OLED entraine aussi une augmentation de la tension d'opération.

Les TCO durs, parmi lesquels se trouve notamment le $SnO_2$, sont très résistants notamment à la gravure humide, et on peut les graver uniquement par gravure sèche. En plus, ils fonctionnent bien comme anode pour l'empilement OLED, avec une parfaite conservation de la tension d'opération comparé à une anode en Al/TiN.

Selon cette caractéristique essentielle de l'invention on utilise comme espaceur optique principalement une couche de TCO doux, mais on protège cette couche par une fine couche de TCO dur qui assure aussi l'interface vers l'empilement de couches organiques du dispositif (couches OLED ou couches photosensibles).

Le concept de TCO « doux » et « dur » se réfère ici à un traitement de décapage humide (appelé aussi traitement de « gravure » humide) de référence, habituellement utilisé en microélectronique, à savoir un décapage avec une solution aqueuse d'hydroxyde de tétraméthylammonium (n° CAS : 75-59-2) à 2,38 % massiques ; un tel produit est commercialement disponible, par exemple auprès de la société ThermoFischer Scientific™ (grade électronique, n° de catalogue 44940. Cette gravure humide est typiquement effectuée à température ambiante. Selon ce concept de TCO « doux » et « dur », un TCO « dur » est un TCO qui résiste significativement mieux à un tel traitement de gravure humide qu'un TCO « doux », cette résistance pouvant être exprimée par la vitesse de gravure spécifique dans des conditions identiques. Dans le cadre de la présente invention, quelle que soit la nature chimique de ces couches de TCO, il faut les sélectionner l'une par rapport à l'autre de manière à ce que cette différence en résistance audit traitement de gravure humide de référence soit respectée. Il convient de préciser que dans le présent contexte, les termes « dur » et « doux » ne se réfèrent pas à des caractéristiques mécaniques, mais uniquement à la résistance à la gravure humide.

Bien évidemment, l'invention n'est pas limitée à des TCO qui sont « durs » et « doux » par rapport à ce traitement de référence indiqué ci-dessus. Dans le procédé selon l'invention on peut utiliser d'autres produits et procédés de gravure, qui doivent cependant être sélectionnes de manière à ce que les TCO qui sont, l'un par rapport à l'autre, respectivement, « doux » et « dur » dans les conditions du traitement de référence, soient aussi, l'un par rapport à l'autre, respectivement, « doux « et « dur » dans les conditions du traitement de gravure choisi.

Au sein du même dispositif optoélectronique selon l'invention, il n'est pas nécessaire que toutes les couches de TCO « dur » aient la même composition, chimique, et que toutes les couches de TCO « doux » aient la même composition, pourvue que dans les conditions de gravure humide sélectionnées dans le procédé selon l'invention qui sont utilisées par "une étape donnée, les couches de TCO Concernées se comportent comme une couche de TCO dur et comme une couche de TCO doux.

On sait que la résistance d'un TCO peut dépendre de la technique de dépôt. Dans le cadre de la présente invention, une technique de dépôt avantageuse, est la technique de dépôt de couches atomiques (ALD, Atomic Layer Déposition).

De manière préférée, dans le cadre de la présente invention le TCO dur, le TCO doux et le traitement de gravure sont choisies de manière à ce que la vitesse de gravure du TCO dur soit inférieure au dixième de la vitesse de gravure du TCO doux, de manière plus préférée inférieure au centième, et de manière encore plus préférée inférieure au millième.

Pour le TCO doux la vitesse de gravure (exprimée typiquement en nm/min) doit être adaptée au procédé de gravure humide utilisé. Si la vitesse de gravure est trop élevée, le temps entre la fin de la gravure et le rinçage risque d'induire une surgravure difficile à contrôler ; la vitesse de gravure dépend de la nature chimique du TCO, de son procédé de dépôt et de la nature du traitement de gravure (notamment de l'agent de gravure, de sa concentration et de la température).

Typiquement, les TCO « doux » utilisables pour réaliser la présente invention sont des TCO à base de ZnO, ce ZnO pouvant être dopé, par exemple au gallium (oxyde appelé GZO), à l'aluminium (AZO), au bore, et/ou au béryllium. Un autre système de TCO « doux » typique est le TCO à base d'oxyde d'indium, qui peut être dopé, notamment à l'étain ; un tel oxyde connu sous le sigle ITO (Indium Tin Oxide) est largement utilisé en microélectronique et optoélectronique. L'ITO ne peut être déposé par ALD ; l'oxyde d'indium peut être déposé par ALD, mais c'est un procédé assez difficile à maîtriser pour garantir une stoschiométrie correcte.

Typiquement, les TCO « durs » utilisables pour réaliser la présente invention sont des TCO à base de $SnO_2$,

ce SnO$_2$ pouvant être dopé, par exemple à l'arsenic, au fluoré, à l'azote, au niobium, au phosphore, à l'antimoine.

Nous décrivons ici un premier mode de réalisation ne faisant pas partie de l'invention avec deux groupes de pixels de couleur différente, désignés ici par R et G.

En référence à la figure 8, on approvisionne un substrat **150**, en l'occurrence une tranche de silicium avec des circuits structurées selon la technologie CMOS qui sont configurés pour adresser les pixels (ou lire la tension ou le courant des pixels dans le cas d'un capteur) ; cette technologie est connue en tant que telle et ne sera pas expliquée ici. Ce substrat **150** comporte une couche d'isolant **151** qui peut notamment être un oxyde, un nitrure ou un oxynitrure ; on utilise typiquement du Si$_3$N$_4$. Les contacts électriques entre vers les pixels sont pris par l'intermédiaire de canaux verticaux aménagés à travers cette couche d'isolant par gravure; cela est également connu.

Sur cette couche d'isolant **151** est déposée l'électrode réfléchissante inférieure **152**. Cette électrode inférieure **152** peut comporter une ou plusieurs couches. Elle peut par exemple être en argent, aluminium, cuivre, chrome ou un autre métal à haute réflectivité, et dans ce cas une seule couche peut être suffisante. Elle peut aussi comporter plusieurs couches, comme cela a été décrit ci-dessus et comme cela est illustré sur la figure 8. A ce titre, elle peut comporter par exemple une couche métallique **153** (typiquement de l'aluminium) pris en sandwich entre une première couche **155** (inférieure) et une deuxième couche **154** (supérieure). Cette première **155** et deuxième **154** couches sont conductrices, et au moins ladite deuxième couche est aussi transparente **154** si elle n'est pas en matériau métallique ; elles peuvent être en nitrure de titane, avec une épaisseur typiquement d'environ 50 nm pour la couche inférieure **155** et d'environ 7 nm pour la couche supérieure **154**. On aboutit donc ainsi pour l'électrode inférieure **152** à une structure TiN / métal / TIN (par exemple TiN/Al/TiN). Alternativement, la deuxième couche (supérieure) **154** peut être en argent ; cette variante est préférée par rapport au nitrure de titane car l'argent présente une très bonne réflectivité optique, et l'interface avec le TCO qui sera déposé sur ladite couche supérieure **154** dans la séquence d'étapes qui suit sera de bonne qualité. Ladite couche d'argent peut aussi être déposée au-dessus de ladite deuxième couche (supérieure) **154** en nitrure, ce qui donne une structure TiN / métal / TiN / argent, par exemple TiN/Al/TiN/Ag, énuméré d'en bas vers le haut.

Dans une première séquence d'étapes du procédé illustrée de manière schématique sur la figure 8, on dépose sur cette électrode réfléchissante inférieure **152** une première couche **158** de TCO. Cette couche de TCO doit être facile à graver par gravure humide, elle est ainsi appelée ici une couche de TCO « doux », par opposition à une couche de TCO résistante à une gravure humide, qui est appelée ici une couche de TCO « dur ». D'une manière générale, on peut intercaler entre la surface supérieure de l'électrode réfléchissante inférieure **152** et ladite première couche de TCO **156** (en TCO « doux ») une fine couché de TCO « dur » (non montrée sur ces figures), appelée ici « couche TCO dur de base », qui protège l'électrode inférieure **152**. A titre de TCO doux on peut utiliser par exemple une couche d'AZO, de ZnO ou de ITO, et à titre de TCO « dur » une couche de SnOz.

Ladite fine couche de TCO dur qui protège l'électrode Inférieure **152** est visible sur la figure 31 (numéro de référence **680)** et sur les figures 42 et 43, et sera discutée en plus grand détail dans ce contexte. Il convient de noter que si cette couche **680** est présente, elle ne fera pas partie de ce qui est appelé ici « bicouche » : une « bicouche », tel que ce terme est utilisé dans la présente demande, comprend toujours une première couche (comptée à partir du substrat) de TCO doux et une deuxième couche de TCO dur.

Comme cela est illustré sur la figure 9, dans une deuxième séquence d'étapes on crée sur cette couche **158** de TCO doux un dépôt structuré **158** de résine photosensible, par des procédés photolithographiques connus de l'homme du métier. L'espacement d, entre deux zones voisines **158a,158b** de résine photosensible correspond à l'espacement entre deux pixels voisins. Sur cette figure 9, comme pour les figures qui suivent, afin de ne pas surcharger ces figures, l'électrode inférieure **152** n'est plus représentée avec ses trois couches qui sont la première couche (inférieure) de nitrure **155,** la couche métallique **153** et la deuxième couche (supérieure) de nitrure **154,** mais comme une seule couche avec le repère numérique **152.**

Dans une troisième séquence d'étapes on procède à la gravure humide de la couche **158** de TCO doux. Dans le cas mentionné ci-dessus où on a intercalé entre la surface supérieure de l'électrode inférieure et la première couche de TCO doux une couche de TCO dur, cette dernière n'est pas enlevée par ledit traitement de gravure humide.

Ensuite on enlève, par un procédé à sec, qui est typiquement un plasma d'oxygène, la résine photosensible **158** ; il en résulte la structure montrée schématiquement sur la figure 10.

Dans une quatrième étape on dépose une deuxième couche **160** de TCO. Cette couche doit être significativement plus résistante à la gravure humide que la couche de TCO doux **156 ;** pour cette raison cette couche est appelée une couche de TCO « dur ». Comme indiqué ci-dessus, on peut utiliser par exemple une couche de SnO$_2$. La structure qui en résulte est illustrée schématiquement sur la figure 11. Cette couche doit être très fine, elle présente avantageusement une épaisseur comprise entre 3 nm et 12 nm.

Dans une cinquième séquence d'étapes on crée sur cette couche **160** de TCO dur un dépôt **182** structuré de résine photosensible, de manière à ce que l'espacement d$_2$ entre deux zone voisines **162a, 162b** de résine photorsensible corresponde à l'espacement entre deux pixels R,G voisins. Cela est illustré schématiquement sur la figure 12. On note que ce dépôt structuré de résine photosensible comprend un dépôt **162a** qui est déposé au-dessus de la couche structurée **158** de TCO doux, et un autre dépôt **162b** photosensible qui est déposé entre deux zones voisines **156a,**

**156b** de TCO doux.

Dans une sixième séquence d'étapes on procède à la gravure sèche de l'ensemble des couches **160** de TCO dur, d'éventuels résidus de la couche TCO douce **158** et de l'électrode réfléchissante **152** pour séparer les pixels, suivi d'un décapage humide de la résine photosensible **162**. Ladite gravure sèche est avantageusement effectuée par RIE (Reactive-Ion Etching, gravure réactive ionique) ou IBE (Ion Beam Etching, gravure au faisceau d'ions). On obtient ainsi une structure illustrée schématiquement sur la figure 13.

Dans une septième séquence d'étapes on dépose un élément de remplissage **164** dans l'espace entre deux pixels voisins, par exemple par des techniques photolithographiques. Cela est illustré schématiquement sur la figure ,14.

Dans une huitième séquence d'étapes on dépose sur cette surface structurée l'empilement OLED **170,** commun à tous les pixels, et une électrode supérieure semi-réfléchissante **166** (appelée aussi « top électrode ») qui est également commune à tous les pixels. Cela est illustré schématiquement sur la figure 15, qui montre schématiquement deux groupes de pixels **168a, 168b,** formé chacun de deux types de pixels **167a,167b** de couleur différente. Ladite électrode supérieure 168 doit être semi-réfléchissante et semi-transparente ; elle forme l'un des deux réflecteurs de la cavité optique. Dans le cas d'un micro-afficheur OLED à émission par le haut (« top émission »), c'est à travers elle que la lumière générée par l'empilement OLED quitte le dispositif optoélectronique; comme cela sera expliqué en plus grand détail ci-dessous, si le dispositif optoélectronique est un détecteur, c'est à travers elle que la lumière entre dans le dispositif pour être détecté par l'empilement organique qui se trouve alors à la place de l'empilement OLED.

On obtient ainsi un dispositif optoélectronique avec deux groupes de pixels **167a, 167b,** chaque groupe de pixels présentant une cavité optique d'épaisseur optique différente, désignés $d_R$ et $d_G$, respectivement. Les cavités optiques sont formées entre l'électrode inférieure **152** du pixel, qui est réfléchissante, et l'électrode semi-transparente et semi-réfléchissante **166** en haut. L'empilement organique peut être selon la destination du dispositif optoélectronique un empilement émissif de type OLED ou un empilement de type photodiode organique. En l'occurrence, l'un des pixels **167a** est formé sur une couche TCO qui est formée à partir de deux couches **156,160** de matériaux TCO différents, l'un **156** doux, l'autre **160** dur, alors que l'autre des pixels **167b** sont formés sur une couche TCO qui n'est formée qu'à partir d'une seule couche **160** de TCO, qui est une couche dure.

On note que même si la couche de TCO peut être composée de deux couches **158,180** chimiquement différentes, elle agit dans ce dispositif optoélectronique comme un espaceur optique unique, et dans cette fonction elle ici est désignée par le numéro de référence **157** (visible sur la figure 16) ; le fait qu'elle soit composée de deux couches chimiquement différentes **156,180** et de dureté différente est motivé uniquement par des considérations pratiques en relation avec la production industrielle de dispositifs optoélectroniques à haut rendement optique et fiables. L'indice de réfraction des deux couches de TCO **156,160** est avantageusement proche pour limiter la perte de lumière par réflexions multiples.

Ce dispositif peut être utilisé pour réaliser un écran d'affichage avec deux couleurs primaires, par exemple rouge (R) et vert (G). Il peut également être utilisé pour réaliser un détecteur de lumière répondant dans deux zones spectrales différentes ; dans ce cas tous les chemins optiques sont inversés et l'empilement OLED **170** émetteur de lumière sera remplacé par un empilement de couches détecteur de lumière.

On observe que la gravure sèche de la sixième « étape est une gravure directionnelle qui enlève le TCO dur **160** dans l'espace de largeur *d2* entre deux zones voisines (voir le passage de la figure **12** à la figure **13**), mais qui n'enlève pas les parois verticales (flancs) de la couche de TCO dur **160,** qui demeurent visibles sur les figure 13 pour les pixels du groupe de ceux qui présentent la cavité optique plus épaisse (épaisseur $d_R$ sur la figure 15). Ainsi, les flancs de la couche de TCO dur **160** protègent les flancs de la couche de TCO doux **156b** sur laquelle ladite couche de TCO dur **180** a été déposée, pendant les étapes de gravure sèche (sixième séquence d'étapes, voir figure 13) et de dépôt de l'élément de remplissage **164** (septième séquence d'étapes, voir figure 14). Ainsi, on obtient un espaceur optique dont les couches de TCO **156b, 160** présentent une excellente définition géométrique avec des bords nets et sains.

On montre sur la figure 16 de manière plus précise et agrandie les couches de l'empilement OLED **170** pour les deux groupes de pixels, **167a** (R) et **167b** (G). Cet empilement OLED comporte une deuxième électrode (top-électrode) **166** et une ou plusieurs couches d'encapsulation (non montrées sur les figures) afin de protéger le dispositif. Ladite électrode supérieure **166** doit être semi-transparente car c'est à travers elle que la lumière émise par ledit dispositif optoélectronique quitte le dispositif s'il s'agit d'un émetteur de lumière, et c'est à travers elle que la lumière qui doit être détectée par ledit dispositif entre dans le dispositif s'il s'agit d'un détecteur de lumière.

La figure 16 fait également apparaître une représentation plus fine de l'empilement OLED, qui est représenté ici avec trois ensembles de couches : un premier ensemble **171** comporte successivement, énuméré d'en bas vers le haut, une couche d'injection de trous (abrégée HIL, Hole Injection Layer), une couche de transport de trous (appelée HTL, Hole Transport Layer), et une couche de blocage d'électrons (abrégée EBL, Electron Blocking Layer). Un deuxième ensemble **175** de couches comporte la ou les couches émissives (abrégée EML, Emissive Layer). Un troisième ensemble **179** de couches comporte successivement et couche de blocage de trous (abrégée HBL, Hole Blocking Layer), une couche de transport d'électrons (abrégée ETL, Electron Transport Layer) et une couche d'injection d'électrons (abrégée EIL, Electron Injection Layer).

Les épaisseurs optiques $d_R$ et $d_G$, ainsi que la position optique d'intensité maximum de la couche émettrice **175**, $z_y$ sont choisies de façon à former pour les pixels du groupe G **167b** une cavité qui permet d'extraire un maximum de lumière verte en direction de la normale, et pour les pixels du groupe **R 167a** un maximum de lumière rouge. Pour cela on peut réaliser un empilement OLED **170** émettant par exemple un spectre avec un pic dans la zone jaune (yellow, abrégé ici Y) du spectre visible.

Au lieu d'utiliser un empilement OLED **170** avec un pic d'émission dans la zone jaune du spectre visible, on peut aussi utiliser un empilement OLED **1700** à deux couches émettrices **1751,1752** différentes, en occurrence R et G ; un tel dispositif est illustré sur la figure 17. Dans ce cas, les épaisseurs $d_R$ et $d_G$, ainsi que la position d'intensité maximum des couches émettrices **1751,1752,** désignée respectivement $z_R$ et $z_G$, sont à optimiser afin d'obtenir une émission maximum à la normale pour les deux groupes de pixels **1670a,1670b.**

Il est également possible d'utiliser un empilement OLED du type tandem, soit avec deux cellules Y (illustré de manière schématique sur la figure 18), soit avec une cellule R et une cellule G (illustré de manière schématique sur la figure 19). Dans le dernier cas, l'ordre des cellules G et R peut être aussi inversé (non montré sur les figures). Dans ces cas, les épaisseurs $d_R$ et $d_G$, ainsi que la position d'intensité maximum des couches émettrices, $z_{Y1}$ et $z_{Y2}$ ou $z_R$ et $z_G$ sont à optimiser afin d'obtenir une émission maximum à la normale pour les deux groupes de pixel.

La structure des empilements de type tandem est illustrée sur les figures 18 et 19 ; sur ces deux figures les numéros de références qui désignent la même chose que sur les figures 8 à 17 ont été augmentés de 100. Les empilements OLED **270** de type tandem comprennent deux ensembles d'empilements **2701,2702,** séparés par une couche **274** de génération de charges (abrégé CGL, Charge Génération Layer). Chacun des deux ensembles d'empilement **2701,2702** comporte les trois ensembles de couches présentés en relation avec la figure 16, à savoir (d'en bas vers le haut) : un premier ensemble **271,276** de couches EBL, HTL et HIL, un deuxième ensemble **272,278** comportant la couche émissive EML, et un troisième ensemble **273,279** comprenant les couches EIL, HBL, ETL.

On définit les épaisseurs optiques $d_I$, I=R, G comme la somme des épaisseurs e multipliés avec l'index optique n de toutes les couches qui se trouvent entre la surface supérieure de l'électrode 152 et la surface inférieure de l'electrode166. Par exemple par rapport à la Figure 16 on obtient :

$$d_R = n_{156}{}^* e_{156} + n_{160}{}^* e_{160} + n_{171}{}^* e_{171} + n_{175}{}^* e_{175} + n_{179}{}^* e_{179}$$

$$d_G = n_{160}{}^* e_{160} + n_{171}{}^* e_{171} + n_{175}{}^* e_{175} + n_{179}{}^* e_{179}.$$

Dans ces équations l'indice de chaque paramètre se réfère au repère numérique utilisé sur la figure 16.

De la même façon, on définit la position optique de l'émission $z_J$, J=Y, R, G comme la somme des épaisseurs e multipliés avec l'index optique n de toutes les couches qui se trouvent entre la position de l'intensité maximum d'émission de la couche émettrice correspondante et la surface inférieure de l'électrode **166**. Par exemple par rapport à la Figure 16 on obtient, sous l'hypothèse que l'intensité maximum d'émission de la couche émettrice **175** se trouve au milieu de la couche :

$$z_Y = 0.5{}^* n_{175}{}^* e_{175} + n_{179}{}^* e_{179}$$

Dans cette équation l'indice de chaque paramètre se réfère au repère numérique utilisé sur la figure 16.

A titre d'exemple, si l'on fixe dans la géométrie de la figure 16 les épaisseurs optiques $d_G$ à 102 nm, $d_R$ à 130 nm et l'épaisseur $e_{160}$ de la couche de TCO dur **160** à 4 nm, la couche **156** de TCO doux doit avoir une épaisseur optique de 28 nm ce qui corresponde à une épaisseur physique de 15,5 nm si son index optique est de 1,8, sachant que l'empilement organique **170** et la couche de TCO dur **180** sont communs à tous les pixels (et ont dont la même épaisseur pour le pixel **167a** et le pixel **167b).**

En relation avec les figures 20 à 27, nous décrivons maintenant un deuxième mode de réalisation, qui est un mode de réalisation selon l'invention, avec trois groupes de pixels **387a, 367b, 367c** de couleur différente, désignés ici par R, G et B. Les numéros de référence qui désignent la même chose que sur les figures 8 à 17 ont été augmentés de 200.

La première partie du procédé est analogue à ce qui a été décrit précédemment pour le dispositif à deux couleurs, jusqu'à la quatrième séquence d'étapes incluse, avec un jeu de masques de photolithographie adapté à une géométrie à trois groupes de pixels différents. On obtient ainsi après la quatrième séquence d'étapes un produit intermédiaire représenté schématiquement sur la figure 20. Aux emplacements **387a, 367b** des groupes de-pixels R et G il présente une couche structurée de TCO, comprenant une première couche **3561** de TCO doux et une première couche **3601** de TCO dur. A l'emplacement **387c** du groupe du pixel B on n'a pas de couche TCO doux.

On dépose ensuite une deuxième couche **3582** de TCO doux sur l'ensemble de la structure, comme cela est illustré sur la figure 21. Dans la prochaine étape on dépose à l'emplacement **367a** du groupe de pixels R une couche de résine photosensible **332a,** par des techniques photolithographiques connues. Cela est illustré sur la figure 22. Ensuite on effectue une gravure humide pour enlever de manière sélective ladite deuxième couche de TCO doux **3582** aux endroits accessibles, i.e. non protégées par la résine photosensible **332a.** La couche de TCO dur **3601** protège la première couche de TCO doux **3561** de l'emplacement **367b** du groupe de pixels G. Ensuite on enlève la résine photosensiblet **332a** par un procédé de gravure sèche, typiquement au plasma d'oxygène.

Ensuite on dépose une deuxième couche **3602** de TCO dur sur l'ensemble de la structure, pour aboutir à la structure illustrée sur la figure 23. Sur cette deuxième couche **3602** on dépose, à l'aide de techniques photolithographiques connues, une couche structurée **3820** de résine photosensible, comme indiqué sur la figure 24. Cette couche de résine photosensible **3620a, 3620b, 3620c** protège chaque groupe de pixels **387a, 367b, 387c** pendant la gravure sèche pour séparer les pixels. Cette gravure sèche a pour objet d'enlever l'ensemble des couches de TCO dur **3801 et 3802,** d'éventuels résidus de TCO doux ainsi que la ou les couches de l'électrode réfléchissante **352** aux endroits non protégés par la résine photosensible, c'est-à-dire à l'espace entre les pixels. Ladite gravure sèche peut être une gravure au faisceau d'ions, comme mentionnée ci-dessus.

On enlève ensuite la couche de résine photosensible **3620** par un procédé de décapage humide et obtient ainsi la structure illustrée sur la figure 25. On dépose ensuite un élément de remplissage **364,** par exemple en résine photosensible, dans l'espace entre deux pixels voisins, comme décrit ci-dessus ; le résultat est illustré sur la figure 28. Sur cette structure on dépose d'abord l'empilement OLED 370, puis l'électrode commune **368,** qui doit être semi-transparente. On obtient ainsi trois groupes de pixels **367a,367b,367c** avec des espaceurs optiques d'épaisseur optique différente pour chacun des trois groupes de pixels. Ce dispositif est illustré sur la figure 27.

On note, comme dans le premier mode de réalisation décrit en relation avec les figures 8 à 15, que les bords (que l'on appelle aussi les flancs) des couches de TCO des espaceurs optiques des groupes de pixels verts **367b** et rouge **367a** sont protégés par une couche de TCO dur **3602.** Ces flancs peuvent être verticaux ou inclinés, ce qui dépend de détails du procédé de fabrication ; un exemple est montré sur la figure 40.

Par ailleurs, comme cela est visible sur la figure 28, pour le pixel rouge **367a** dont l'espaceur optique comporte deux couches de TCO doux **3561,3562,** on note que la couche de TCO doux supérieure **3561** est totalement encapsulée par la couche inférieure de TCO dur **3601,** la couche supérieure de TCO dur **3602** et les flancs de ladite couche supérieure de TCO dur **3602.** Une sorte de boîte de TCO dur est ainsi créée, protégeant la couche de TCO doux interne. Ainsi, le procédé selon invention conduit à des espaceurs optiques d'une grande qualité, d'une excellente définition géométrique, d'une grande homogénéité et d'une bonne stabilité dans le temps. On voit sur la figure 40 précitée un exemple d'une telle « boîte » de TCO sur (en l'occurrence $SnO_2$) qui protège le TCO doux (en l'occurrence AZO) d'un pixel vert (deuxième groupe) : la couche d'AZO présente une épaisseur de 45 nm.

Un dispositif selon l'invention peut être utilisé pour réaliser un écran d'affichage avec trois couleurs primaires, par exemple rouge (R), vert (G) et bleu (B), afin réaliser un écran couleur du type connu sous l'appellation « full color ». Pour cela, plusieurs modes de réalisation sont possibles. On peut par exemple réaliser un empilement OLED **470** comprenant une ensemble **575** de trois couches émissives différentes **5712,5710,5711** émettant un spectre blanc avec trois pics dans le domaine bleu, vert et rouge du spectre, qui est protégé par une deuxième électrode (top-électrode) semi-transparente **468,** et par une ou plusieurs couches d'encapsulation (non montrées sur les figures) afin de protéger le dispositif. Un tel dispositif est montré de manière schématique sur la figure 28. Dans cet exemple, les trois couches émettrices **5712,5710,5711** formant l'ensemble **575** de couche organiques se succèdent directement, la première **5712** et la troisième **5711** (compté du bas) étant en contact avec, respectivement, un premier ensemble **571** et un troisième **579** ensemble de couches organiques, qui ont les mêmes fonctions que les ensembles **171** et **179** expliqués ci-dessus en relation avec la figure 16.

Le résultat est donc un dispositif avec trois groupes des pixels **467a,487b,467c,** chaque groupe de pixel étant caractérisé par une cavité optique d'épaisseur optique différente, désignée $d_R$, $d_G$ et $d_B$ respectivement. Les cavités sont formées entre l'électrode **452** du pixel qui est réfléchissante, et l'électrode semi-transparente et semi réfléchissante **466** en haut. Les épaisseurs $d_R$, $d_G$ et $d_B$ ainsi que la position d'intensité maximum de la couche émettrice, $z_w$ sont choisi de façon à former pour le groupe de pixels B **467c** une cavité qui permet d'extraire, à partir de la lumière générée par l'empilement OLED, qui peut être une lumière blanche, un maximum de lumière bleue en direction de la normale, pour le groupe de pixels G **467b** un maximum de lumière verte, et pour le groupe de pixels R **467a** et un maximum de lumière rouge.

On note que sur cette figure, le paramètre zw se réfère à une émission blanche qui résulte de l'émission émanant des couches émissives de lumière de couleur bleue **5712,** verte **5710** et rouge **5711.** Pour chacune de ces trois couches, on peut définir la position d'intensité maximum de la couche émettrice, désignée ci-dessous par les paramètres $z_B$, $z_G$ et $z_R$, respectivement ; ces paramètres ne sont pas portés sur la figure 28 afin de ne pas la surcharger.

On peut également générer l'émission blanche avec une combinaison d'un émetteur bleu et d'un émetteur jaune (non montré sur les figures).

Il est également possible d'utiliser une structure OLED de type tandem, soit avec une cellule émettrice de lumière bleue B et une cellule émettrice de lumière jaune Y, soit avec une cellule émettrice de lumière B et une cellule émettrice de lumière rouge et verte RG. La première variante est illustrée sur la figure 29, la deuxième sur la figure 30.

Dans la cellule tandem de la <u>figure 29</u>, l'empilement OLED **570** comprend deux empilements OLED **5701,5702** séparés par une couche de génération de charges **574**. Le premier empilement **5701** (compté à partie du substrat) présente la succession de couches **571** HIL,HTL et EBL qui a été décrite ci-dessus, puis une couche émissive **572** (en l'occurrence avec la couleur d'émission bleu), puis la succession de couches **573 EIL,** ETL, HBL qui a déjà été décrite ci-dessus.

Le deuxième empilement **5702** présente la même structure fonctionnelle, avec les couches la succession de couches **576** HIL, HTL, EBL, une couche émissive **578** de couleur d'émission (jaune) différente de celle de l'empilement **5701,** et la succession de couches **579** EIL, ETL, HBL. La couche semi-réfléchissante et conductrice **566,** commune à tous les pixels, forme à la fois le réflecteur supérieur de la cavité optique et électrode supérieure commune du dispositif.

La cellule tandem de la <u>figure 30</u> présente une structure similaire, sauf que dans le deuxième empilement OLED **5702,** la couche émissive **578** n'est pas caractérisée par une couleur d'émission jaune, mais elle est réalisée sous la forme de deux couches émissives **5781,5782** dont la première émet dans le rouge, la deuxième dans le vert.

L'ordre des cellules B et Y ou B et RG peut être aussi inversé par rapport à ce qui est montré dans ces figures. Les épaisseurs $d_R$, $d_G$ et $d_B$, ainsi que la position d'intensité maximum des couches émettrices, $z_Y$ et $z_B$ ou $z_{RG}$ et $z_B$ peuvent être optimisées afin d'obtenir une émission maximum à la normale pour les trois groupes de pixels.

Comme déjà expliqué avant, on définit les épaisseurs optiques $d_I$, I=R, G, B comme la somme des épaisseurs e multipliés avec l'index optique n de toutes les couches qui se trouvent entre la surface supérieure de l'électrode **4521552** et la surface inférieure de l'électrode **468/566**. Par exemple par rapport à la Figure 30 on obtient :

$$d_R = n_{5561}{}^* e_{5561} + n_{5601}{}^* e_{5601} + n_{5562}{}^* e_{5562} + n_{5602}{}^* e_{5602} + n_{570}{}^* e_{570}$$

$$d_G = n_{5561}{}^* e_{5561} + n_{5601}{}^* e_{5601} + n_{5602}{}^* e_{5602} + n_{570}{}^* e_{570}$$

$$d_G = n_{5601}{}^* e_{5601} + n_{5602}{}^* e_{5602} + n_{570}{}^* e_{570}$$

Dans ces équations l'indice de chaque paramètre se réfère au repère numérique utilisé sur la figure 30.

De la même façon, on définit la position optique de l'émission $z_J$, J=Y,R,G,RG,W comme la somme des épaisseurs e multipliés avec l'index optique *n* de toutes les couches qui se trouvent entre la position de l'intensité maximum d'émission de la couche émettrice correspondante et la surface inférieure de l'électrode **468/566.** Par exemple, par rapport à la Figure 30 on obtient, sous l'hypothèse que l'intensité maximum d'émission des couches émettrices **572/578** se trouve au milieu de la couche:

$$Z_{RG} = 0.5{}^* n_{578}{}^* e_{578} + n_{579}{}^* e_{579}$$

$$Z_B = 0.5{}^* n_{572}{}^* e_{572} + n_{573}{}^* e_{573} + n_{574}{}^* e_{574} + n_{576}{}^* e_{576} + n_{578}{}^* e_{578} + n_{579}{}^* e_{579}$$

Dans ces équations l'indice de chaque paramètre se réfère au repère numérique utilisé sur la figure 30.

Les tableaux 1 à 3 montrent le résultat d'une optimisation des principaux paramètres pour différentes configurations. Cette optimisation vise les meilleurs performances électro-optiques, notamment un compris entre émission, efficacité et spectre d'émission CIE, pour déterminer les paramètres clé du dispositif, à savoir les épaisseurs $d_R$, $d_G$ et $d_B$ et la position d'intensité maximum des couches émettrices zw (lumière blanche pour la géométrie de la figure 28), ou $z_B$ et $z_Y$ (pour la géométrie de la figure 29), ou $z_B$, $z_G$ et $z_R$ (pour la géométrie de la figure 30). Cette optimisation se base sur une valeur moyenne de l'indice optique des couches formant l'empilement organique de 1,7981 à la longueur d'onde de 500 nm, sachant que les indices optiques des différentes couches organiques sont très proches. Elle se base également sur un indique optique à 500 nm du TCO doux (AZO dans cet exemple) de 1,92448293 et du TCO dur (SnO$_2$ dans cet exemple) de 2,027. Les références 8, 9, 14 et 15 se réfèrent à une émission de premier ordre pour le pixel jaune (Y) et à une émission de second ordre pour le pixel bleu (B).

Table 1 : Géométrie de la figure 28 (cellule simple RGB)

| Ref | ord | $d_S$[nm] | | $d_G$(nm) | | $d_B$[nm] | | $z_G$[nm] | | $z_B$[nm] | | $z_X$[nm] | | $z_G$[nm] | | $z_B$[nm] | |
|---|---|---|---|---|---|---|---|---|---|---|---|---|---|---|---|---|---|
| | | de | á | de | á | de | á | de | á | de | á | de | á | de | á | de | á |
| 1 | 1 | 120 | 156 | 178 | 214 | 197 | 233 | 60 | 114 | 45 | 88 | | 64 | | 121 | 70 | 132 |
| 2 | | 120 | 156 | 178 | 214 | 197 | 233 | 56 | 107 | 45 | | 88 67 | | 127 | | | |

Reference 1 : trois émetteurs, à avoir R,G.B.

Référence 2 : deux émetteurs, á savoir B, Y.

La colonne « ord » indique l'ordre de rémission optique.

**Table 2 : Géométrie de la figure 29 (cellule tandem YB)**

| Ref | ordre | $d_S$[nm] | | $d_G$[nm] | | $d_G$[nm] | | $z_B$[nm] | | $z_Y$[nm] | |
|---|---|---|---|---|---|---|---|---|---|---|---|
| | | de | à | de | a | de | à | de | à | de | à |
| 3 | 1 | 120 | 156 | 178 | 214 | 197 | 233 | 45 | 88 | 67 | 128 |
| 4 | 2 | 333 | 372 | 451 | 487 | 509 | 564 | 260 | 310 | 57 | 124 |
| 5 | | 336 | 372 | 451 | 487 | 509 | 564 | 53 | 92 | 133 | 372 |
| 6 | 1 (B), 2 (Y) | 120 | 156 | 456 | 502 | 524 | 579 | 45 | 88 | 59 | 128 |
| 7 | 1 (Y), 2 (B) | 347 | 383 | 174 | 210 | 193 | 229 | 55 | 95 | 66 | 124 |

Réferences 356 et 7 : cellule en bas = B, cellule en haut = **Y.**

Référence 4 : cellule en bas = Y, cellule en haut = B.

**Table 3 : Géométrie de la figure 30 (cellule tandem RG/B)**

| Réf | ordre | $d_S$[nm] | | $d_G$[nm] | | $d_B$[nm] | | | | $z_B$[nm] $z_G$[nm] | | $z_R$[nm] | |
|---|---|---|---|---|---|---|---|---|---|---|---|---|---|
| | | de | à | de | à | de | à | de | à | de | à | de | à |
| 8 | 1 | 120 | 156 | 178 | 214 | 179 | 233 | 24 | 109 | 36 | 150 | 39 | 163 |
| 9 | 2 | 336 | 372 | 451 | 487 | 509 | 564 | 235 | 335 | 23 | 146 | 25 | 169 |
| 10 | | 336 | 372 | 451 | 487 | 509 | 564 | 34 | 112 | 316 | 439 | 356 | 508 |
| 11 | 1(B),2(RG) | 347 | 393 | 174 | 210 | 193 | 229 | 243 | 345 | 35 | 147 | 39 | 160 |
| 12 | 1(RG),2(B) | 347 | 383 | 174 | 210 | 193 | 229 | 35 | 115 | 35 | 147 | 39 | 160 |

References 8, 10, 12 : cellule en bas = B, cellule en haut = RG

Référence 9 et 11: celule en bas = RG, celule en haut = B

Ainsi, selon un premier mode de réalisation particulier qui se prête notamment aux micro-afficheurs, le dispositif optoélectronique selon l'invention possède au moins trois groupes de pixels, qui sont, respectivement, des pixels R (rouge), G (vert) et B (bleu), les pixels de chaque groupe possédant une couche émettrice ou (une couche photosensible dans le cas où ledit dispositif est un photodétecteur), qui émet (ou détecte) dans le spectre rouge, vert ou bleu, respectivement, avec une épaisseur optique $d_B$ comprise entre environ 110 nm et environ 160 nm, une épaisseur optique $d_G$ comprise entre environ 160 nm et environ 220 nm, une épaisseur optique $d_R$ comprise entre environ 190 nm et environ 240 nm, un paramètre désignant la position optique d'intensité maximum de lumière blanche zw compris entre environ 50 nm et environ 130 nm (de préférence entre environ 60 nm et environ 115 nm), un paramètre désignant la position optique d'intensité maximum de lumière bleue $z_B$ compris entre environ 40 nm et environ 100 nm (de préférence entre environ 45 nm et environ 90 nm), un paramètre désignant la position optique d'intensité maximum de lumière verte $z_G$ compris entre environ 60 nm et environ 130 nm (de préférence entre environ 65 nm et environ 120 nm), et un paramètre désignant la position optique d'intensité maximum de lumière rouge $z_R$ compris entre environ 65 nm et environ 140 nm (de préférence entre environ 70 nm et environ 130 nm).

Dans une variante avantageuse de ce mode de réalisation, l'épaisseur optique $d_B$ est comprise entre environ 120 nm et environ 155 nm, l'épaisseur optique de est comprise entre environ 175 nm et environ 215 nm, l'épaisseur optique $d_R$ est comprise entre environ 195 nm et environ 230 nm, le paramètre zw est compris entre entre environ 60 nm et environ 115 nm (de préférence entre environ 75 nm et environ 100 nm), le paramètre $z_B$ est compris entre environ 45 nm et environ 90 nm (de préférence entre environ 55 nm et environ 80 nm), le paramètre $z_G$ est compris entre environ 65 nm et environ 120 nm (de préférence entre environ 70 nm et environ 110 nm) et le paramètre $z_R$ est compris entre environ 70 nm et environ 130 nm (de préférence entre environ 80 nm et environ 120 nm).

Selon un deuxième mode de réalisation particulier qui se prête notamment aux micro-afficheurs, le dispositif optoélectronique selon l'invention possède au moins trois groupes de pixels, qui sont, respectivement, des pixels R (rouge), G (vert) et B (bleu), les pixels de chaque groupe ayant une structure de type tandem dans laquelle la cellule du bas possède une couche émettrice (ou une couche photosensible) qui émet (ou détecte) dans le spectre bleu, et la cellule du haut possède une couche émettrice (ou une couche photosensible) qui émet (ou détecte) dans le spectre jaune ou rouge et vert, avec une épaisseur optique $d_B$ comprise entre environ 110 nm et environ 160 nm (de préférence entre environ 120 nm et environ 155 nm), une épaisseur optique $d_G$ comprise entre environ 160 nm et environ 220 nm (de préférence entre environ 175 nm et environ 215 nm), une épaisseur optique $d_R$ comprise entre environ 190 nm et environ 240 nm (de préférence entre environ 195 nm et environ 230 nm), un paramètre désignant la position optique d'intensité maximum de lumière bleue $z_B$ compris entre environ 40 nm et environ 90 nm (de préférence entre environ 45 nm et environ 85 nm), et un paramètre désignant la position optique d'intensité maximum de lumière jaune (ou rouge et verte) $z_Y$ compris entre environ 60 nm et environ 140 nm (de préférence entre environ 65 nm et environ 130 nm).

Dans une variante avantageuse de ce mode de réalisation, l'épaisseur optique de est comprise entre environ 120 nm et environ 155 nm, l'épaisseur optique $d_G$ est comprise entre environ 175 nm et environ 215 nm, l'épaisseur optique $d_R$ est comprise entre environ 195 nm et environ 230 nm, le paramètre $z_B$ est compris entre environ entre environ 45 nm et environ 85 nm (de préférence entre environ 55 nm environ 80 nm), et le paramètre zy est compris entre environ 65 nm et environ 130 nm (de préférence entre environ 80 nm et environ 115 nm).

Selon un troisième mode de réalisation particulier qui se prête notamment aux micro-afficheurs, le dispositif optoélectronique selon l'invention possède au moins trois groupes de pixels, qui sont, respectivement, des pixels R (rouge), G (vert) et B (bleu), les pixels de chaque groupe ayant une structure de type tandem dans laquelle la cellule du bas possède une couche émettrice (ou une couche photosensible) qui émet (ou détecte) dans le spectre bleu, et la cellule du haut possède une couche émettrice (ou une couche photosensible) qui émet (ou détecte) dans le spectre jaune ou rouge et vert, avec une épaisseur optique $d_B$ comprise entre environ 320 nm et environ 390 nm (de préférence entre environ 330 nm et environ 375 nm), une épaisseur optique $d_G$ comprise entre environ 425 nm et environ 500 nm (de préférence entre environ 450 nm et environ 490 nm), une épaisseur optique $d_R$ comprise entre environ 500 nm et environ 575 nm (de préférence entre environ 510 nm et environ 565 nm), un paramètre désignant la position optique d'intensité maximum de lumière bleue $z_B$ compris entre environ 45 nm et environ 100 nm (de préférence entre environ 50 nm et environ 95 nm), et un paramètre désignant la position optique d'intensité maximum de lumière jaune (ou rouge et vert) $z_Y$ compris entre environ 120 nm et environ 390 nm (de préférence entre environ 130 nm et environ 375 nm).

Dans une variante avantageuse de ce mode de réalisation, l'épaisseur optique de est comprise entre environ 335 nm et environ 375 nm), une épaisseur optique $d_G$ comprise entre 450 nm et environ 490 nm), une épaisseur optique $d_R$ comprise entre environ 510 nm et environ 565 nm), un paramètre $z_B$ compris entre environ 55 nm et environ 90 nm (de préférence entre environ 60 nm et environ 85 nm), et un paramètre $z_Y$ compris entre environ 130 nm et environ 375 nm (de préférence entre environ 135 nm et environ 370 nm).

En relation avec les figures 33 à 39, nous décrivons maintenant un autre mode de réalisation selon l'invention avec trois groupes de pixels **767a, 767b, 767e** de couleur différente, désignée ici par R, G et B. Les numéros de référence qui désignent la même chose que sur les figures 20 à 27 ont été augmentés de 400.

Le point de départ est le produit intermédiaire représenté schématiquement sur la figure 33. Il peut être obtenu par une variante du procédé décrit en relation avec le produit intermédiaire montré sur la figure 20 en utilisant un jeu de masques de photolithographie adapté à ce nouveau mode de réalisation. On obtient ainsi après la quatrième séquence d'étapes un produit intermédiaire représenté schématiquement sur la figure 33. A l'emplacement **767b** du groupe de pixels G il présente une couche structurée de TCO, comprenant une première couche **7561** de TCO doux et une première couche **7601** de TCO dur. Aux emplacements **767a** et **767c** des groupes de pixels R et B, respectivement, on n'a pas de couche TCO doux la en dessous de ladite première couche **7801** de TCO dur.

On dépose ensuite une deuxième couche **7562** de TCO doux sur l'ensemble de la structure, comme cela est illustré sur la figure 34. Dans une prochaine étape on dépose à l'emplacement **767a** du groupe de pixels R une couche de résine photosensible **762a,** par des techniques photolithographiques connues. Cela est illustré sur la figure 35. Ensuite on effectue une gravure humide pour enlever de manière sélective ladite deuxième couche de TCO doux **7562** aux endroits accessibles, i.e. non protégées par la résine photosensible **762a.** La couche de TCO dur **7601** protège la première couche de TCO doux **7561** de l'emplacement **767b** du groupe de pixels G. Ensuite on enlève la couche de résine photosensible **762a** par un procédé de décapage sèche, typiquement au plasma d'oxygène.

Ensuite on dépose une deuxième couche **7802** de TCO dur sur l'ensemble de la structure, pour aboutir à la structure illustrée sur la figure 36. Sur cette deuxième couche **7602** on dépose, à l'aide de techniques photolithographiques connues, une couche structurée **7620** de résine photosensible, comme indiqué sur la figure 24. Cette couche structurée de résine photosensible comprend ici trois zones **7620a, 7620b, 7620c** et protège ainsi chaque groupe de pixels **767a, 767b, 767c** pendant la gravure sèche pour séparer les pixels. Cette gravure sèche a pour objet d'enlever aux endroits non protégés par la résine photosensible **7620** l'ensemble des couches de TCO dur **7601** et **7602,** d'éventuels résidus de TCO doux, ainsi que la ou les couches de l'électrode réfléchissante **752** aux endroits non protégés par la résine photosensible, c'est-à-dire à l'espace entre les pixels. Ladite gravure sèche peut être une gravure au faisceau d'ions, comme mentionnée ci-dessus.

On enlève ensuite la couche de résine photosensible **7620** par un procédé de décapage humide et obtient ainsi la structure illustrée sur la figure 38. On dépose ensuite un élément de remplissage **764,** par exemple en résine photosensible, dans l'espace entre deux pixels voisins, comme décrit ci-dessus ; le résultat est illustré sur la figure 39. Sur cette structure on dépose ensuite l'empilement OLED et puis l'électrode commune, qui doit être semi-transparente. On obtient ainsi trois groupes de pixels avec des espaceurs optiques d'épaisseur optique d différente pour chacun des trois groupes de pixels. Ce dispositif n'est pas illustré par une figure ; il est similaire à celui de la figure 27, sauf pour ce qui concerne l'empilement de couches de TCO dur et doux sur le pixel **367a.**

Ce dispositif peut être utilisé pour réaliser un écran d'affichage avec trois couleurs primaires, par exemple rouge (R), vert (G) et bleu (B), afin réaliser un écran couleur du type connu sous l'appellation « full color », comme cela a été décrit ci-dessus.

L'invention peut être réalisée dans de nombreuses autres variantes.

Une première variante est illustrée sur la figure 31 : on a intercalé une fine couche **680** de TCO dur (tel que du $SnO_2$) entre l'électrode de pixel **552** (i.e. l'électrode inférieure qui est réfléchissante) et la première couche de TCO doux **3561** (qui peut être en AZO). Il s'ensuit que pour chaque groupe de pixels **367a,367b** au-delà du premier groupe **387c,** c'est-à-dire en l'occurrence pour le deuxième **367b** et troisième **367a** groupe, la première couche **3561,3562** de toutes les bicouches est totalement encapsulée par une couche **3601,3602,680** d'un deuxième matériau transparent et conducteur : le TCO dur protège le TCO doux.

La figure 41 illustre de manière schématique le principe de cette variante : on note que le pixel du troisième groupe **367a** présente un espaceur optique d'une hauteur $h3$ qui est supérieure à la hauteur $h2$ de l'espaceur optique des pixels du deuxième groupe **367b.** L'espaceur optique des pixels du troisième groupe **367a** est formé par deux bicouches, celui des pixels du deuxième groupe **367b** par une seule bicouche. Par ailleurs, pour chacun de ces deux groupes, les couches de TCO doux **3561,3562** sont encapsulées par une couche de TCO dur **3601.** Selon une variante du procédé décrit ci-dessus (cette variante n'étant pas décrite ici en plus grand détail), on peut obtenir un produit d'une structure différente qui remplit la même fonction ; cette structure est illustrée sur la figure 42 : dans cette variante l'espaceur optique des pixels du troisième groupe **367a** présente une hauteur $h2$ identique à celle de la figure 41, mais il n'y a, pour ce troisième groupe de pixels **367a,** qu'une seule bicouche ; le troisième groupe de pixels **367a** présente par rapport aux pixels du deuxième groupe **367b** une épaisseur de la couche de TCO doux **7562** qui est plus grande (la relation $h3 > h2$ s'applique toujours). La figure 40 représente un extrait d'une telle structure selon la figure 42 : l'épaisseur de la couche AZO (visible sur la figure) est de 45 nm pour le pixel vert, et de 95 nm pour le pixel rouge (non visible sur la figure 40).

Dans une deuxième variante, qui est compatible avec toutes les autres variantes et tous les modes de réalisation décrits ici, on ajoute des filtres colorés **695a,695b,695c** appropriés. Cela est illustré de manière schématique sur la figure 32. La présence de filtres colorés ne conduit pas à une perte significative d'intensité lumineuse car la lumière émise par chaque pixel n'est pas blanche mais de couleur (ce qui résulte de l'effet technique des cavités optiques de longueurs optiques différentes). L'avantage est une meilleure définition et un meilleur contrôle des couleurs générées par chaque groupe de pixels. A cet égard, il convient de noter que la lumière émise par les pixels peut comporter une faible composante du deuxième (voire même du troisième) ordre ; en particulier, la lumière bleue comporte toujours une composante de lumière rouge, ce qui correspond au pic de deuxième ordre ; cette composante d'ordre supérieure est avantageusement absorbée par un filtre qui ne laisse passer que la lumière du premier ordre.

Dans l'exemple de la figure 32, les filtres colorés **695a, 695b, 695c** sont posées sur une couche de lissage **690** transparente, qui est une option ; elle peut être en matière polymérique.

Il est très avantageux de prévoir un système d'encapsulation (non montré sur les figures) sur l'électrode supérieur **166, 266, 366, 466.** Il comprend au moins une couche, et de préférence plusieurs couches. Il comprend une première couche d'alumine, déposée par une technique de dépôt conforme qui est de préférence la technique dite de dépôt de couches atomique (ALD, Atomic Layer Déposition). Il peut comprendre une deuxième couche de polymère II peut comprendre une troisième couche d'alumine, également par ALD. Cette séquence de couches alternées d'alumine et de polymère peut être répétée une ou plusieurs fois, la dernière couche étant de préférence une couche d'alumine ou de l'oxyde de titane. Un tel système d'encapsulation protège le dispositif conte l'humidité et l'oxygène, qui risqueraient de dégrader certaines des couches, et en particulier les couches faisant partie de l'empilement organique.

Comme indiqué ci-dessus, le dispositif optoélectronique selon l'invention peut être réalisé sous la forme d'un dispositif d'émission de lumière de type OLED ; il peut s'agir d'un micro-afficheur. La meilleure luminosité obtenue selon l'invention engendre une consommation électrique réduite et une durée de vie plus longue. Un tel micro-afficheur à haute luminance peut être utilisé par exemple dans des lunettes de type réalité augmentée ou dans des dispositifs de type HUD (Afficheur tête haute, en anglais Head-Up Display). Il est réalisé avantageusement avec au moins trois groupes de pixels de couleur différente.

Le dispositif optoélectronique selon l'invention peut également être réalisé comme un capteur optique multispectral, à base de photodiodes organiques. Un tel capteur transforme la lumière incidente en un signal électrique, qui est généré par un empilement photoactif de couches, qui sont de préférence des couches organiques. Dans un mode de réalisation (non illustré sur les figures), cet empilement photoactif de couches comprend au moins un premier matériau, qui est un donneur d'électrons, et un deuxième matériau, qui est un accepteur d'électrons. En fonction du choix des matériaux et de la longueur optique des cavités un tel capteur peut être réalisé pour répondre dans différents domaines du spectre lumineux, par exemple dans le domaine visible et/ou dans le domaine du proche infrarouge.

Un tel capteur est utile notamment dans le domaine spectral du proche infra-rouge, qui s'étend typiquement entre environ 780 nm et environ 10 $\mu$m. Pour réaliser un tel capteur, lesdits matériaux sont caractérisés par le fait que la différence entre l'énergie du niveau occupé le plus haut (HOMO - HIghest Occupied Molecular Oribital) dudit premier matériau et l'énergie du niveau inoccupé le plus bas (LUMO - Lowest Unoccupied Molecular Orbital) dudit deuxième matériau est inférieure à environ 1,6 eV.

Ledit premier matériau peut par exemple être une phthalocyanine (telle que la phthalocyanine de zinc ou de fer) ou une amine aromatique (telle que la N,N,N',N'-Tetrakis(4-methoxyphenyl)benzidine, abrégée MeO-TPD, n° CAS 122738-21-0) ou encore un polythiophène (tel que le Poly[2,5-bis(3-tetradecylthiophen-2-yl)thieno[3,2-b]thiophène], abrégé PBTTT, n° CAS 888491-19-8). Ces matériaux peuvent être déposés sous vide. Ledit deuxième matériau peut être un fullerène, tel que le C60 ; ces matériaux peuvent également être déposés sous vide.

Un tel dispositif optoélectronique peut être réalisé sous la forme d'un spectromètre (en prévoyant une pluralité de groupes de pixels dont chaque groupe présente une cavité optique de longueur différente), et/ou sous la forme d'une caméra à résolution spatiale et spectrale, en prévoyant une pluralité de pixels constitués chacun d'une pluralité de groupes de pixels avec une cavité optique de longueur différente.

L'invention est définie par les revendications annexées.

## Revendications

1. Dispositif optoélectronique comprenant un substrat (350, 450, 550, 750) et un empilement de couches organiques (370, 470) comprenant au moins une couche active pouvant être une couche émettrice de lumière (572, 575, 578) ou une photodiode, disposée entre une surface réfléchissante, ou entre la surface d'une couche transparente déposée directement sur ladite surface réfléchissante, et une surface semi-réfléchissante disposées face à face à une distance donnée et formant une cavité optique d'une longueur optique $d$ donnée, et ledit dispositif comprenant au moins trois groupes de pixels (367a, 367b, 367c; 767a, 767b, 767c) dont chanque groupe est **caractérisé par** une cavité de longueur optique $d$ différente, ladite cavité comprenant un nombre de bicouches disposées entre ledit substrat et ledit empilement de couches organiques, chaque bicouche étant formée d'une première couche (3561, 3562, 7561, 7562) transparente et conductrice d'un premier matériau transparent et conducteur, et d'une deuxième couche (3601, 3602, 7601, 7602) transparente et conductrice d'un deuxiéme matériau transparent et conducteur, en contact direct avec ladite première couche transparente et conductrice, ledit premier matériau étant différent dudit deuxième matériau, et dans ledit dispositif :

   - pour un premier groupe (367c, 767c) de pixels le nombre de bicouches est de zéro :
   - pour un deuxième groupe (367b, 767b) de pixels, le nombre de bicouches est de un,
   - pour un troisième groupe (367a, 767a) de pixels, le nombre de bicouches est de deux ou de un, mais dans ce dernier cas, ladite première couche de la bicouche associée au troisième groupe de pixels est plus épaisse que celle du deuxième groupe de pixels,
   - pour chaque groupe additionnel de pixels, si présent, le nombre de bicouches augmente de un par rapport au groupe précédent ou reste le même, mais dans ce dernier cas, ladite première couche de la bicouche associée au groupe additionnel de pixels est plus épaisse que celle du précédent groupe de pixels ;
   - sachant que le comptage des groupes en premier, deuxième, troisième et, le cas échéant, ainsi de suite, suite un ordre de la valeur de $d$ croissant, et dans ledit dispositif pour chacune de ces bicouches ladite première couche conductrice et transparente, comptée à partir dudit substrat, présente une résistance plus faible à un traitement de gravure humide que ladite deuxième couche conductrice et transparente, et dans ledit dispositif pour chaque group de pixels au-delà du premier, au moin ladite première couche de la bicouche la plus éloignée du substrat est protégée latéralement par ladite deuxième couche de la bicouche.

2. Dispositif selon la revendication 1, dans lequel pour chaque groupe de pixels au-delà du premier, ladite première couche de la bicouche la plus éloignée du substrat est totalement encapsulée par ladite deuxième couche de la bicouche.

3. Dispositif selon la revendication 1 ou 2, dans lequel pour chaque groupe de pixels au-delà du premier, ladite première couche de toutes les bicouches est totalement encapsulée par une couche d'un deuxième matériau transparent et conducteur.

4. Dispositif selon l'une quelconque des revendications 1 à 3, dans lequel ladite surface réfléchissante est couvert d'une couche dudit deuxième matériau transparent et conducteur.

5. Dispositif optoélectronique delon l'une quelconque des revendications 1 à 4, dans lequel ledit traitement de gravure humide est un traitement avec une solution aqueuse d'hydroxide de tétraméthylammonium à 2.38 % massiques à température ambiante.

6. Dispositif optoélectronique selon l'une quelconque des revendications 1 à 5, dans lequel dans chacune desdites bicouches, ladite première couche transparente et conductrice présente une vitesse de gravure spécifique V1 qui au moins dix fois supérieure, de préférence au moin cent fois supérieure, et encore plus préférentiellement au moins mille fois supérieure que la vitesse de gravure spécifique V2 de ladite deuxième couche transparente.

7. Dispositif optoélectronique selon l'une quelconque des revendications 1 à 6, dans lequel:

   ledit premier matériau transparent et conducteur est sélecionné dans le groupe formé par : le ZnO ; les oxydes dopés à base de ZnO, le dopage étant de préférence au gallium et /ou à l'aluminium et/ou au bore et/ou au béryllium ; l'oxyde d'indium ; les oxydes dopés à base d'oxyde d'indium, le dopage étant de préférence à l'étain, et / ou dans lequel ledit deuxième matériau transparent et conducteur est sélectionné dans le groupe formé par ; le $SnO_2$, le $SnO_2$ dopé, le dopage étant de préférance à l'arsenic et/ou au fluore et/ou à l'azote et/ou au niobium et/ou au phosphore et/ou à l'antimoine et/ou à l'alumimium et/ou au titane.

8. Dispositif selon l'une quelconque des revendications 1 à 7, dans lequel ledit empilement de couches organiques est en contact direct avec, d'une part, ladite surface réfléchissante ou une couche transparente déposée sur ladite surface réfléchissante, et/ou, d'autre part, avec ladite surface semi-réfléchissante.

9. Dispositif selon l'une quelconque des revendications 1 à 8, dans lequel ledit empilement de couches organique forme une revêtement continu sur l'ensemble des pixels, et de préférence dans lequel il comprend une couche semi-transparente et conductrice, déposée au-dessus dudit empilement de couches organiques, qui forme également-ment un revêtement continu sur l'ensemble des pixels.

10. Dispositif optoélectronique selon l'une quelconque des revendications 1 à 9, dans lequel ledit substrat est un substrat de type CMOS pourvu de circuits permettant un adressage individuel ou une lecture individuelle des pixels.

11. Dispositif optoélectronique selon l'une quelconque des revendications 1 à 10, dans lequel il s'agit d'un micro-afficheur OLED ou d'un capteur de lumière multi-spectral.

12. Procédé de fabrication pour un dispositif optoélectronique selon l'une quelconque des revendications 1 à 11, dans lequel :

   - on dépose d'abord une couche (3561) transparente et conductrice d'un premier matériau transparent et conducteur sur ladite première surface réfléchissante ou sur une couche transparente et conductrice d'un deuxième matériau déposée sur ladite première surface réfléchissante,
   - on dépose un premier masque qui délimite un deuxième et un troisième groupe de pixels (367b, 367a) et protège leur emplacement,
   - on enlève par gravure humide ladite première couche transparente et conductrice aux endroits non protégés par ledit premier masque, ces endroits non protégés comprenant l'emplacement prévu pour un premier groupe de pixels (376c), et on enlève ledit premier masque,
   - on dépose une première couche (3601) transparente et conductrice d'un deuxième matériau transparent,

- on dépose une couche (3562) transparente et conductrice d'un premier matériau transparent et conducteur,
- on dépose un deuxième masque (332a) qui délimite ledit troisième groupe de pixels (367a) et protège leurs emplacements,
- on enlève par gravure humide ladite couche (3562) transparente et conductrice d'un premier matériau transparent et conducteur aux endroits non protégés par ledit deuxième masque, ces endroits non protégés comprenant l'emplacement prévu pour ledit deuxième et ledit premier groupe de pixels (367b, 367c), et on enlève ledit deuxième masque,
- on dépose une deuxième couche (3602) transparente et conductrice d'un deuxième matériau transparent et conducteur,
- on dépose un troisième masque (3620a, 3620b, 3620c) qui délimite lesdits premier, deuxième et troisième groupe de pixels et protège leur emplacement,
- on enlève par gravure sèche lesdites première et deuxième couche (3601, 3602) d'un deuxième matériau transparent et conducteur ainsi que couche réfléchissante (352) et, si elle est présente, ladite couche dudit deuxième matériau transparent et conducteur la recouvrant aux endroits non protégés par ledit troisième masque,

**13.** Procédé de fabrication pour un dispositif optoélectronique avec trois groupes de pixels selon la revendication 12, dans lequel on poursuit le procédé par les étapes suivantes:

- on dépose un élément de remplissage (364) dans chaque espace entre deux pixels voisins,
- on dépose un empilement (370) de couches organiques commun à tous les pixels, on dépose au-dessus dudit empilement de couches organiques une couche électrode semi-réfléchissante (366), commune à tous les pixels

**14.** Procédé selon l'une quelconque des revendications 12 à 13, dans lequel le dépôt des couches transparentes et conductrices dudit deuxième matériau transparent et conducteur est effectué par la technique de dépôt de couches atomiques.

**Patentansprüche**

**1.** Optoelektronische Vorrichtung, umfassend ein Substrat (350,450,550,750) und einen Stapel organischer Schichten (370,470), der mindestens eine aktive Schicht umfasst, bei der es sich um eine lichtemittierende Schicht (572,575,578) oder um eine Photodiode handeln kann, die zwischen einer reflektierenden Oberfläche, oder zwischen der Oberfläche einer transparenten Schicht, die direkt auf dieser reflektierenden Oberfläche abgeschieden ist, und einer halbreflektierenden Oberfläche, die in einem gegebenen Abstand gegenüberliegend angeordnet ist und einen optischen Hohlraum mit einer gegebenen optischen Länge d bildet,

und wobei die Vorrichtung mindestens drei Gruppen von Pixeln (367a, 367b, 367c;767a,767b,767c) umfasst, von denen jede Gruppe durch einen Hohlraum unterschiedlicher optischer Länge d gekennzeichnet ist, wobei der Hohlraum eine Anzahl von Doppelschichten umfasst, die zwischen dem Substrat und dem Stapel organischer Schichten angeordnet sind, jede Doppelschicht bestehend aus einer ersten transparenten und leitfähigen Schicht (3561,3562,7561,7562) aus einem ersten transparenten und leitfähigen Material, und aus einer zweiten transparenten und leitfähigen Schicht (3601,3602,7601,7602) aus einem zweiten transparenten und leitfähigen Material, das in direktem Kontakt mit der ersten transparenten und leitenden Schicht steht, wobei sich das erste Material vom zweiten Material unterscheidet,
und in welcher Vorrichtung:

- für eine erste Gruppe (367c,767c) von Pixeln die Anzahl der Doppelschichten Null beträgt,
- für eine zweite Gruppe (367b,767b) von Pixeln die Anzahl der Doppelschichten eins beträgt,
- für eine dritte Gruppe (367a,767a) von Pixeln die Anzahl der Doppelschichten zwei oder eins beträgt, im letzteren Fall jedoch die erste Schicht der Doppelschicht, die der dritten Gruppe von Pixeln zugeordnet ist, dicker ist als jene der zweiten Gruppe von Pixeln,
- für jede weitere Gruppe von Pixeln, sofern vorhanden, sich die Anzahl der Doppelschichten im Vergleich zur vorherigen Gruppe um eins erhöht oder gleich bleibt, jedoch im letzteren Fall ist die erste Schicht der Doppelschicht, die der zusätzlichen Gruppe von Pixeln zugeordnet ist, dicker als die der vorherigen Gruppe von Pixeln,
- wobei die Zählung der Gruppen in erste, zweite, dritte und gegebenenfalls usw. in einer Reihenfolge erfolgt, in der der Wert d ansteigt, und wobei in der Vorrichtung für jede dieser Schichten diese erste leitfähige und transparente Schicht, vom Substrat her gezählt, einen geringeren Widerstand gegenüber einer Nassätzbehandlung aufweist als die zweite leitfähige und transparente Schicht, und wobei in der Vorrichtung für jede Gruppe von Pixeln jenseits der ersten zumindest die erste Schicht der am weitesten vom Substrat entfernten Doppelschicht seitlich durch die besagte zweite Schicht der Doppelschicht geschützt ist.

2. Vorrichtung nach Anspruch 1, in welcher für jede Gruppe von Pixeln jenseits der ersten die besagte erste Schicht der am weitetsten vom Substrat entfernten Doppelschicht vollständig von der zweiten Schicht der Doppelschicht eingekapselt ist.

3. Vorrichtung nach Anspruch 1 oder 2, in welcher für jede Gruppe von Pixeln jenseits der ersten die besagte erste Schicht aller Doppelschichten vollständig von einer Schicht aus einem zweiten transparenten und leitfähigen Material eingekapselt ist.

4. Vorrichtung nach einem der Ansprüche 1 bis 3, in welcher die besagte reflektierende Oberfläche mit einer Schicht aus dem zweiten transparenten und leitfähigen Material bedeckt ist.

5. Optoelektronische Vorrichtung nach einem der Ansprüche 1 bis 4, in welcher die besagte Nassätzbehandlung eine Behandlung mit einer wässrigen Lösung von Tetramethylammoniumhydroxid mit 2,38 Gew.-% bei Raumtemperatur ist.

6. Optoelektronische Vorrichtung nach einem der Ansprüche 1 bis 5, bei der in jeder der Doppelschichten die erste transparente und leitfähige Schicht eine spezifische Ätzgeschwindigkeit V1 aufweist, die mindestens zehnmal höher, vorzugsweise mindestens hundertmal höher und besonders bevorzugt mindestens tausendmal höher ist als die spezifische Ätzgeschwindigkeit V2 der zweiten transparenten Schicht.

7. Optoelektronische Vorrichtung nach einem der Ansprüche 1 bis 6, in welcher das erste transparente und leitfähige Material aus der Gruppe ausgewählt ist, die besteht aus: ZnO; dotierten Oxiden auf Basis von ZnO, wobei die Dotierung vorzugsweise Gallium und/oder Aluminium und/oder Bor und/oder Beryllium ist; Indiumoxid; dotierten Oxiden auf der Basis von Indiumoxid, wobei die Dotierung vorzugsweise mit Zinn erfolgt,
und/oder in welcher das zweite transparente und leitfähige Material ausgewählt ist aus der Gruppe bestehend aus: $SnO_2$, dotiertem $SnO_2$, wobei die Dotierung vorzugsweise Arsen und/oder Fluor und/ oder Stickstoff und/oder Niob und/oder Phosphor und/oder Antimon und/oder Aluminium und/oder Titan ist.

8. Vorrichtung nach einem der Ansprüche 1 bis 7, **dadurch gekennzeichnet, dass** der Stapel organischer Schichten in direktem Kontakt mit einerseits der besagten reflektierenden Oberfläche oder einer auf der Oberfläche besagter reflektierenden Schicht aufgebrachten transparenten Schicht steht, und/oder andererseits mit der halbreflektierenden Oberfläche.

9. Vorrichtung nach einem der Ansprüche 1 bis 8, in welcher der Stapel organischer Schichten eine kontinuierliche Beschichtung über allen Pixeln bildet, und vorzugsweise dadurch, dass er eine halbtransparente und leitfähige Schicht umfasst, die über dem Stapel aus organischen Schichten abgeschieden ist, und die ebenfalls eine durchgehende Beschichtung auf allen Pixeln bildet.

10. Optoelektronische Vorrichtung nach einem der Ansprüche 1 bis 9, in welcher das Substrat ein CMOS-Substrat ist, das mit Schaltkreisen ausgestattet ist, die eine individuelle Adressierung oder ein individuelles Lesen von Pixeln ermöglichen.

11. Optoelektronische Vorrichtung nach einem der Ansprüche 1 bis 10, in welcher es sich um ein OLED-Mikrodisplay oder einen multispektralen Lichtsensor handelt.

12. Herstellungsverfahren für eine optoelektronische Vorrichtung nach einem der Ansprüche 1 bis 11, bei dem:

- zunächst eine transparente und leitfähige Schicht (3561) aus einem ersten transparenten und leitfähigen Material auf der ersten reflektierenden Oberfläche oder auf einer auf der ersten reflektierenden Oberfläche abgeschiedenen transparenten und leitfähigen Schicht aus einem zweiten Material abgeschieden wird,
- eine erste Maske abgeschieden wird, die eine zweite und eine dritte Gruppe von Pixeln (367b, 387a) abgrenzt und deren Position schützt,

- die erste transparente und leitfähige Schicht durch Nassätzen an den Stellen entfernt wird, die nicht durch die erste Maske geschützt sind, wobei diese ungeschützten Stellen die für eine erste Gruppe von Pixeln (376c) vorgesehene Stelle umfassen, und die erste Maske entfernt wird,
- eine erste transparente und leitfähige Schicht (3601) aus einem zweiten transparenten Material abgeschieden wird,
- eine transparente und leitfähige Schicht (3562) aus einem ersten transparenten und leitfähigen Material abgeschieden wird,
- eine zweite Maske (332a) abgeschieden wird, die die dritte Gruppe von Pixeln (367a) begrenzt und ihre Positionen schützt,
- die transparente und leitfähige Schicht (3562) aus einem ersten transparenten und leitfähigen Material durch Nassätzen an den Stellen entfernt wird, die nicht durch die zweite Maske geschützt sind, wobei diese ungeschützten Stellen die für die zweite und die erste Gruppe von Pixeln (367b,376c) vorgesehenen Stellen einschließen, und die zweite Maske entfernt wird,
- eine zweite transparente und leitfähige Schicht (3602) aus einem zweiten transparenten und leitfähigen Material abgeschieden wird,
- eine dritte Maske (3620a, 3620b, 3620c) abgeschieden wird, die die erste, zweite und dritte Gruppe von Pixeln abgrenzt und ihre Position schützt,
- die erste und zweite Schicht (3601,3062) aus besagtem zweiten transparenten und leitfähigen Material sowie die reflektierende Schicht (352), und falls vorhanden, die Schicht (680) aus dem zweiten transparenten und leitenden Material, die sie an Stellen bedeckt, die nicht durch die dritte Maske geschützt sind, durch Trockenätzen entfernt werden.

13. Herstellungsverfahren für eine optoelektronische Vorrichtung mit drei Gruppen von Pixeln nach Anspruch 12, bei dem das Verfahren durch die folgenden Schritte fortgesetzt wird:

- ein Füllelement (364) wird in jedem Zwischenraum zwischen zwei benachbarten Pixeln abgeschieden,
- ein Stapel (370) organischer Schichten, der allen Pixeln gemeinsam ist, wird abgeschieden, und über diesem Stapel organischer Schichten wird eine allen Pixeln gemeinsame halbreflektierende Elektrodenschicht (366) abgeschieden.

14. Verfahren nach einem der Ansprüche 12 bis 13, bei welchem die Abscheidung der transparenten und leitfähigen Schichten des besagten zweiten transparenten und leitfähigen Materials durch die Atomlagenabscheidungstechnik erfolgt.

**Claims**

1. Optoelectronic device comprising a substrate (350,450,550,750) and a stack of organic layers (370,470) comprising at least one active layer that can be a light-emitting layer (572,575,578) or a photodiode, disposed between a reflective surface, or between the surface of a transparent layer deposited directly on said reflective surface, and a semi-reflective surface disposed facing one another at a given distance and forming an optical cavity of a given optical length d,

and said device comprising at least three groups of pixels (367a,367b,367c;767a,767b,767c), each group of which is **characterized by** a cavity of a different optical length d, said cavity comprising a number of bilayers arranged between said substrate and said stack of organic layers, each bilayer being formed by a first transparent and conductive layer (3561, 3562, 7561, 7562) of a first transparent and conductive material, and by a second transparent and conductive layer (3601, 3602, 7601, 7602) of a second transparent and conductive material, in direct contact with said first transparent and conductive layer, said first material being different than said second material, and in said device :

- for a for a first group (367c, 767c) of pixels the number of bilayers is zero,
- for a second group (367b,767b) of pixels, the number of bilayers is one,
- for a third group (367a) of pixels, the number of bilayers is two or one, but in the latter case, said first layer of the bilayer associated with the third group of pixels is thicker than that of the second group of pixels,
- for each additional group of pixels, if present, the number of bilayers increases by one with respect to the previous group or remains the same, but in the latter case, said first layer of the bilayer associated with the additional group of pixels is thicker than that of the preceding group of pixels,

- knowing that the counting of the groups into first, second, third and, if necessary, so on follows an increasing order of the value of d,

and in said device, for each of these bilayers said first conductive and transparent layer, counted from said substrate, has a lower resistance to a wet etching treatment than said second conductive and transparent layer, and in said device, for each group of pixels beyond the first, at least said first layer of the bilayer farthest from the substrate is protected laterally by said second layer of the bilayer.

2. Device according to claim 1, wherein for each group of pixels beyond the first, said first layer of the bilayer farthest from the substrate is totally encapsulated by said second layer of the bilayer.

3. Device according to claim 1 or 2, wherein for each group of pixels beyond the first, said first layer of all the bilayers is totally encapsulated by a layer of a second transparent and conductive material.

4. Device according to any one of claims 1 to 3, wherin said reflective surface is covered by a layer of said second transparent and conductive material.

5. Optoelectronic device according to any one of claims 1 to 4, wherein said wet etching treatment is a treatment with an aqueous solution of tetramethylammonium hydroxide at 2.38% by weight at ambient temperature.

6. Optoelectronic device according to any one of claims 1 to 5, wherein in each of said bilayers, said first transparent and conductive layer has a specific etching rate V1 that is at least ten times greater, preferably at least one hundred times greater, and even more preferably at least one thousand times greater than the specific etching rate V2 of said second transparent layer.

7. Optoelectronic device according to any one of claims 1 to 6, wherein said first transparent and conductive material is selected in the group formed by: ZnO; the doped oxides containing ZnO, the doping preferably being with gallium and/or with aluminum and/or with boron and/or with beryllium; indium oxide; the doped oxides containing indium oxide, the doping preferably being with tin,
and/or wherein said second transparent and conductive material is selected from the group formed by: $SnO_2$, doped $SnO_2$, the doping preferably being with arsenic and/or with fluorine and/or with nitrogen and/or with niobium and/or with phosphorus and/or with antimony and/or with aluminum and/or with titanium.

8. Device according to any one of claims 1 to 7, wherein said stack of organic layers is in direct contact with, on the one hand, said reflective surface or a transparent layer deposited on said reflective surface, and/or, on the other hand, with said semi-reflective surface.

9. Device according to any one of claims 1 to 8, wherein said stack of organic layers forms a continuous coating over all the pixels, and preferably wherein it comprises a semitransparent and conductive layer, deposited above said stack of organic layers, which also forms a continuous coating over all the pixels.

10. Optoelectronic device according to any one of claims 1 to 9, wherein said substrate is a substrate of the CMOS type provided with circuits allowing an individual addressing or an individual reading of the pixels.

11. Optoelectronic device according to any one of claims 1 to 10, which is an OLED microdisplay or a multispectral light sensor.

12. Manufacturing method for an optoelectronic device according to any one of claims 1 to 11, wherein:

- first a transparent and conductive layer (3561) of a first transparent and conductive material is deposited on said first reflective surface or on a transparent and conductive layer of a second material deposited on said first reflective surface,
- a first mask is deposited which defines a second and a third group of pixels (367b, 367a) and protects their location,
- said first transparent and conductive layer is removed by wet etching at the locations not protected by said first mask, these non-protected locations comprising the location intended for a first group of pixels (376c), and said first mask is removed,
- a first transparent and conductive layer (3601) of a second transparent material is deposited,

- a transparent and conductive layer (3562) of a first transparent and conductive material is deposited,
- a second mask (332a) that defines said third group of pixels (367a) and protects their locations is deposited,
- said transparent and conductive layer (3562) of a first transparent and conductive material is removed by wet etching at the locations not protected by said second mask, these non-protected locations comprising the location intended for said second and said first group of pixels (367b,376c), and said second mask is removed,
- a second transparent and conductive layer (3602) of a second transparent and conductive material is deposited,
- a third mask (3620a, 3620b, 3620c) that defines said first, second and third group of pixels and protects their location is deposited,
- said first and second layer (3601,3602) of a second transparent and conductive material as well as said reflective layer (352) and, if it is present, said layer of said second transparent and conductive material covering it are removed by dry etching at the locations not protected by said third mask.

13. Manufacturing method for an optoelectronic device with three groups of pixels according to claim 12, wherein the method is continued by the following steps:

- a filling element (364) is deposited in each space between two neighboring pixels,
- a stack (370) of organic layers common to all the pixels is deposited, a semi-reflective electrode layer (366), common to all the pixels, is deposited above said stack of organic layers.

14. Method according to any one of claims 12 to 13, wherein the deposition of the transparent and conductive layers of said second transparent and conductive material is carried out by the technique of atomic layer.

[Fig. 1]

[Fig. 2]

[Fig. 3]

[Fig. 4]

[Fig. 5]

[Fig. 6]

[Fig. 7]

[Fig. 8]

[Fig. 9]

**EP 4 176 468 B1**

[Fig. 10]

[Fig. 11]

[Fig. 12]

[Fig. 13]

[Fig. 14]

28

[Fig. 15]

[Fig. 16]

[Fig. 17]

[Fig. 18]

[Fig. 19]

[Fig. 20]

[Fig. 21]

[Fig. 22]

[Fig. 23]

[Fig. 24]

[Fig. 25]

EP 4 176 468 B1

[Fig. 26]

[Fig. 27]

[Fig. 28]

[Fig. 29]

[Fig. 30]

[Fig. 31]

367a  367b  367c

366  3562
3561  3601  3602  3601
370
3602
364
351
350

3601  352a  3561  352b  352c  680c
680a  3602  680b

[Fig. 32]

367a  367b  367c

3562  3561  695a  695b  695c

366  690
370
3602
364
351
350

3601  352a  3561  352b  352c  680c
680a  3602  680b  680c  3601

[Fig. 33]

767a  767b  767c

7561  7601
752
751  750

[Fig. 34]

[Fig. 35]

[Fig. 36]

[Fig. 37]

[Fig. 38]

[Fig. 39]

[Fig. 40]

[Fig. 41]

367a            367b            367c

3602

-3562-

$h3$

3601

-3561-

$h2$    -3561-

680

352

351

-350-      -350-      -350-

[Fig. 42]

367a            367b            367c

7602

-7562-

$h3$

7601

$h2$    -7561-

680

352

351

-350-      -350-      -350-

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0616488 A
- JP 2003142277 A
- US 6639250 B1
- EP 1450419 B1
- EP 1672962 B1
- US 20090283786 A
- EP 1450419 A
- US 20120229014 A
- US 20060138945 A
- US 20120241782 A1
- US 20160211479 A
- US 20150060811 A1
- US 9972804 B2
- WO 2017029223 A
- EP 3671849 A
- EP 1672962 A

**Littérature non-brevet citée dans la description**

- *CHEMICAL ABSTRACTS,* 75-59-2